(19) **Europäisches Patentamt**
**European Patent Office**
**Office européen des brevets**

(11) **EP 2 692 052 B1**

(12) **EUROPEAN PATENT SPECIFICATION**

(45) Date of publication and mention
of the grant of the patent:
**28.01.2015 Bulletin 2015/05**

(51) Int Cl.:
**H02N 2/00** *(2006.01)*  **B08B 7/02** *(2006.01)*
**G02B 27/00** *(2006.01)*  **H04N 5/217** *(2011.01)*

(21) Application number: **12720657.1**

(22) Date of filing: **22.03.2012**

(86) International application number:
**PCT/JP2012/058285**

(87) International publication number:
**WO 2012/133604 (04.10.2012 Gazette 2012/40)**

(54) **VIBRATION MEMBER DRIVING METHOD, VIBRATING DEVICE, DRIVING DEVICE INCLUDING VIBRATING DEVICE, AND OPTICAL APPARATUS**

ANSTEUERVERFAHREN FÜR EIN SCHWINGELEMENT, SCHWINGVORRICHTUNG, ANTRIEBSVORRICHTUNG MIT DER SCHWINGVORRICHTUNG UND OPTISCHE VORRICHTUNG

PROCÉDÉ D'EXCITATION D'ORGANE DE VIBRATION, DISPOSITIF VIBRANT, DISPOSITIF D'EXCITATION COMPRENANT UN DISPOSITIF VIBRANT ET APPAREIL OPTIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **31.03.2011 JP 2011079565**
**08.03.2012 JP 2012051948**

(43) Date of publication of application:
**05.02.2014 Bulletin 2014/06**

(73) Proprietor: **Canon Kabushiki Kaisha**
**Tokyo 146-8501 (JP)**

(72) Inventors:
• **OHASHI, Kaishi**
**Tokyo 146-8501 (JP)**
• **URAKAMI, Toshifumi**
**Tokyo 146-8501 (JP)**

(74) Representative: **TBK**
**Bavariaring 4-6**
**80336 München (DE)**

(56) References cited:
**WO-A1-2008/093884**   **US-A- 5 001 404**
**US-A1- 2006 207 290**   **US-A1- 2009 206 698**

EP 2 692 052 B1

## Description

### Technical Field

The present invention relates to a vibration member driving method, a vibrating device, a driving device including a vibrating device, and an optical apparatus.

More particularly, the present invention relates to optical apparatuses, such as a camera, a facsimile, a scanner, a projector, a copying machine, a laser beam printer, an ink jet printer, a lens, a binocular, and an image display apparatus. Further, the present invention relates to a vibrating device used as a dust removing device for those optical apparatuses, and to a driving device for driving a driven member with vibrations.

### Background Art

In recent image pickup apparatuses, dust adhering to an optical system during use has become a factor affecting a picked-up image with an increase in resolution of an optical sensor. In particular, because resolution of an image pickup device used in a video camera and a still camera has remarkably increased, an image defect may occur if dust adheres to an optical element arranged in an optical path near the image pickup device.

For example, if dust incoming from the outside or abrasion powder generated from mechanical friction surfaces inside the apparatus adheres to, e.g., an infrared cut filter or an optical low-pass filter, the dust, etc. may be taken into the picked-up image for the reason that a blur occurred at the surface of the image pickup device is held small.

On the other hand, in an image capturing unit of a copying machine, a facsimile, a scanner, etc., a planar original is read by scanning a line sensor relative to the original or by scanning the original relative to the line sensor in close relation.

When dust adheres to a light incident portion for the line sensor, the dust may be taken into a scanned image.

Also, in the so-called flow-reading type of apparatus in which the original is scanned, e.g., a reader section in a facsimile and a copying machine in which the original from an automatic original feeder is read while it - is conveyed, one piece of dust may be taken as a linear image that continues in the original feed direction.

This raises a problem that image quality is greatly degraded.

The image quality can be restored by manually wiping out the dust. However, the dust having adhered during use can be confirmed only after picking up the image.

Stated another way, the dust is taken into the image that has been picked up and scanned before the confirmation. Therefore, image processing with software is to be performed for image correction. In the case of a copying machine, a lot of efforts and time are taken for the image correction because the image is output to a paper medium.

To deal with the problems described above, there are hitherto proposed a dust removing device for removing dust from an image reader section by applying vibrations, and an optical apparatus including the dust removing device (see Patent Literature (PTL) 1).

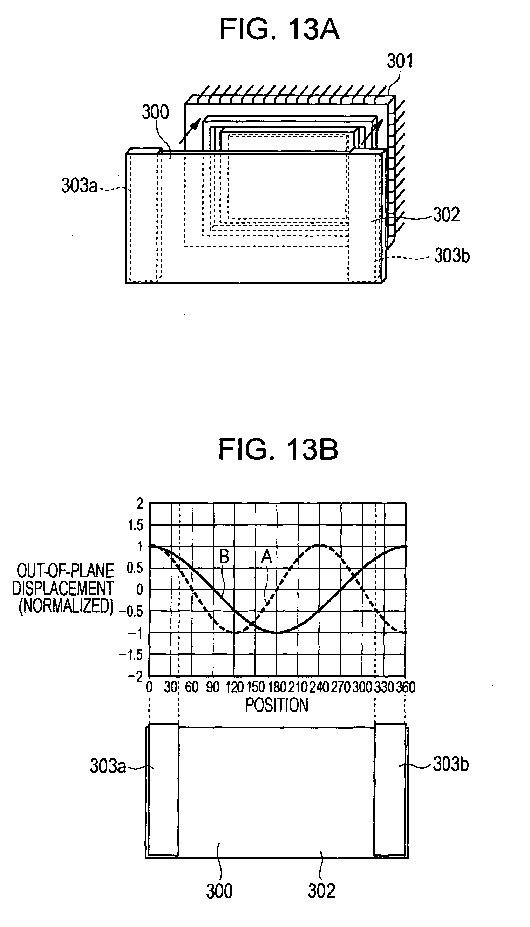

Fig. 13A illustrates the construction of a known vibrating device in the dust removing device disclosed in PTL 1.

A vibrating device 300 is attached to an image pickup device 301 that forms image data by converting a received object image to an electrical signal.

A space on the front side of the image pickup device 301 is surrounded by the vibrating device 300 and the image pickup device 301 in a sealed-off manner. In other words, the vibrating device 300 is joined to the front side of the image pickup device 301 with, e.g., a sealing member interposed therebetween such that a space between the vibrating device 300 and the image pickup device 301 is enclosed.

The vibrating device 300 is made up of an optical element 302 in the form of a rectangular plate, and a pair of electro-mechanical energy conversion elements, i.e., piezoelectric elements 303a and 303b, which are fixed to both ends of the optical element 302 by bonding.

An alternating voltage Va is applied as a driving voltage to the piezoelectric element 303a, and an alternating voltage Vb is applied as a driving voltage to the piezoelectric element 303b.

In a graph of Fig. 13B, A depicts a displacement distribution of a primary out-of-plane bending vibration (standing wave), and B depicts a displacement distribution of a secondary out-of-plane bending vibration (standing wave).

The vertical axis of the graph represents an out-of-plane displacement of the surface of the vibrating device 300 on the side opposite to the side where the image pickup device 301 is disposed. A direction toward the image pickup device 301 is defined to be negative. The horizontal axis of the graph corresponds to a position in the lengthwise direction of the vibrating device 300, as seen from Fig. 13B.

The alternating voltage Va and the alternating voltage Vb are alternating voltages that have periods causing a response in resonance phenomena of the primary out-of-plane bending vibration and the secondary out-of-plane bending vibration. Further, the alternating voltage Va and the alternating voltage Vb differ in time phase from each other.

Thus, a composite vibration resulting from two types of vibrations, i.e., the primary out-of-plane bending vibration and the secondary out-of-plane bending vibration, differing in time phase from each other is excited in the vibrating device 300.

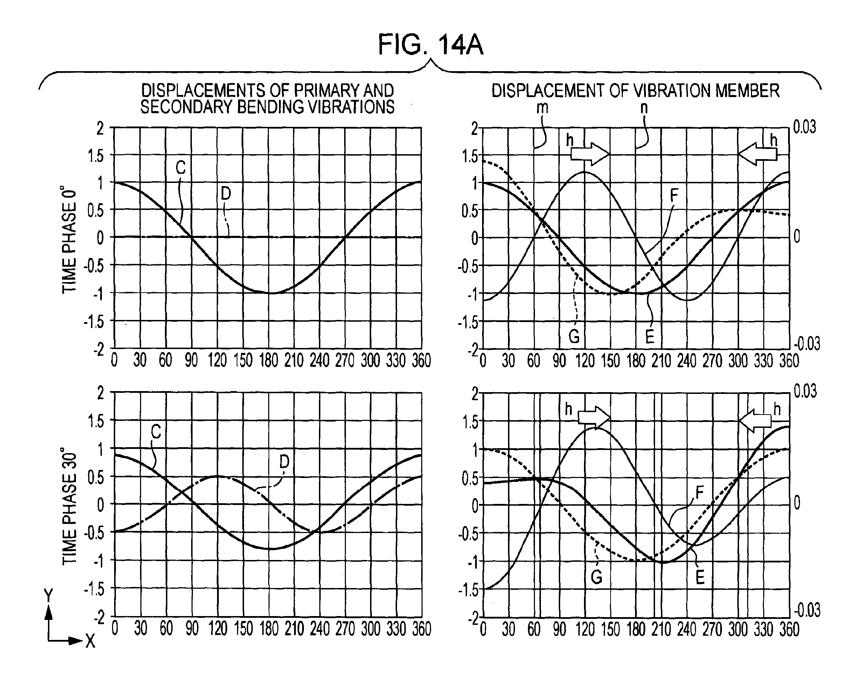

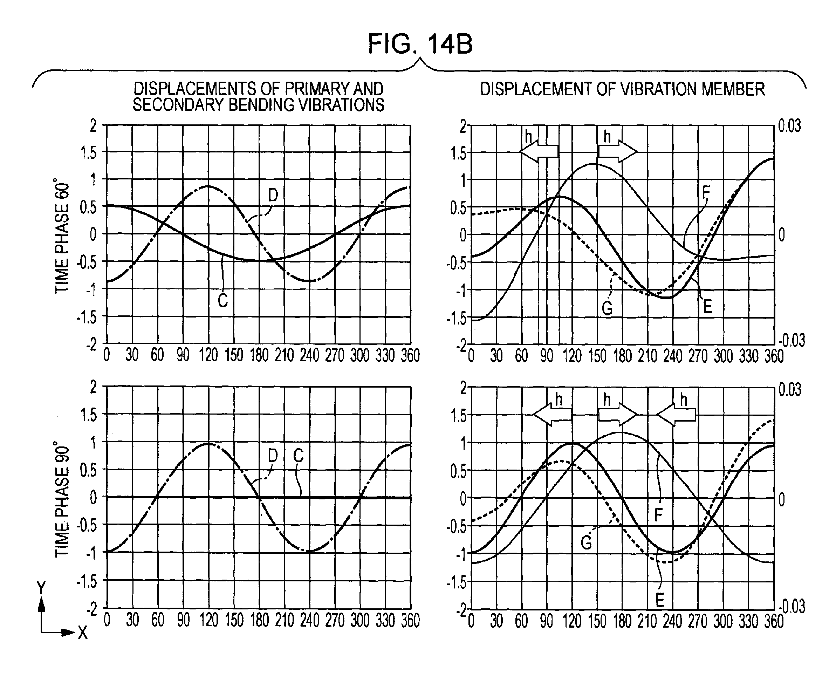

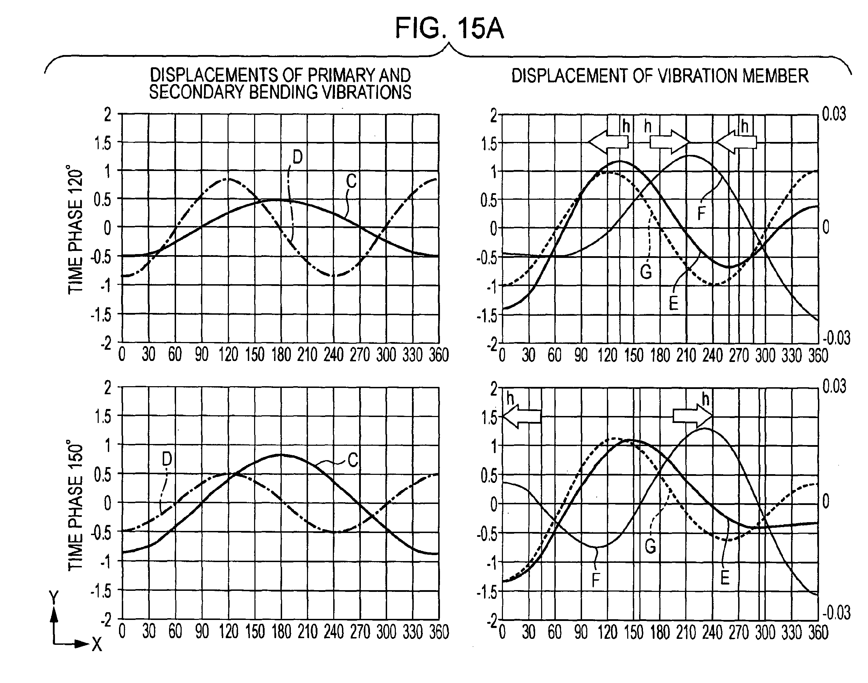

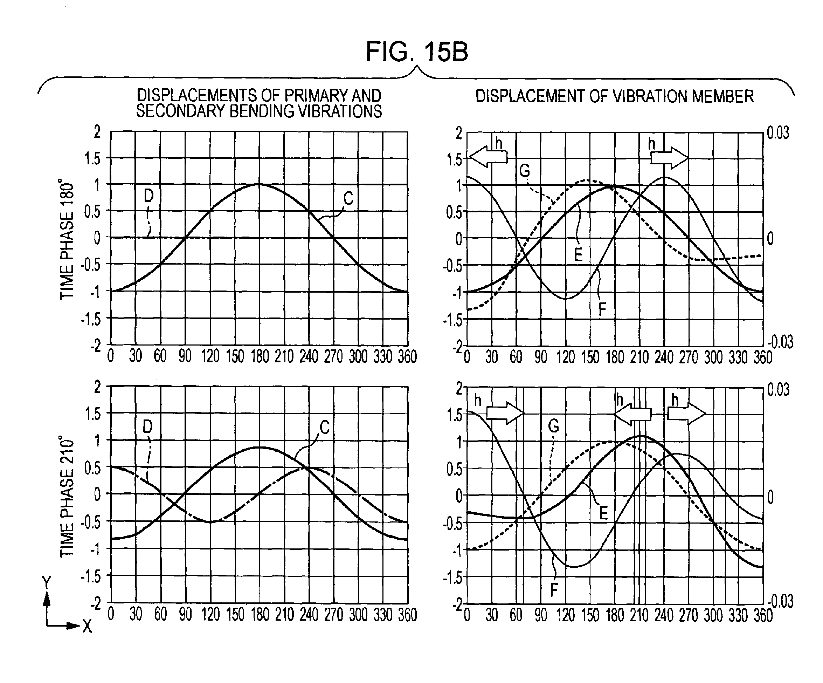

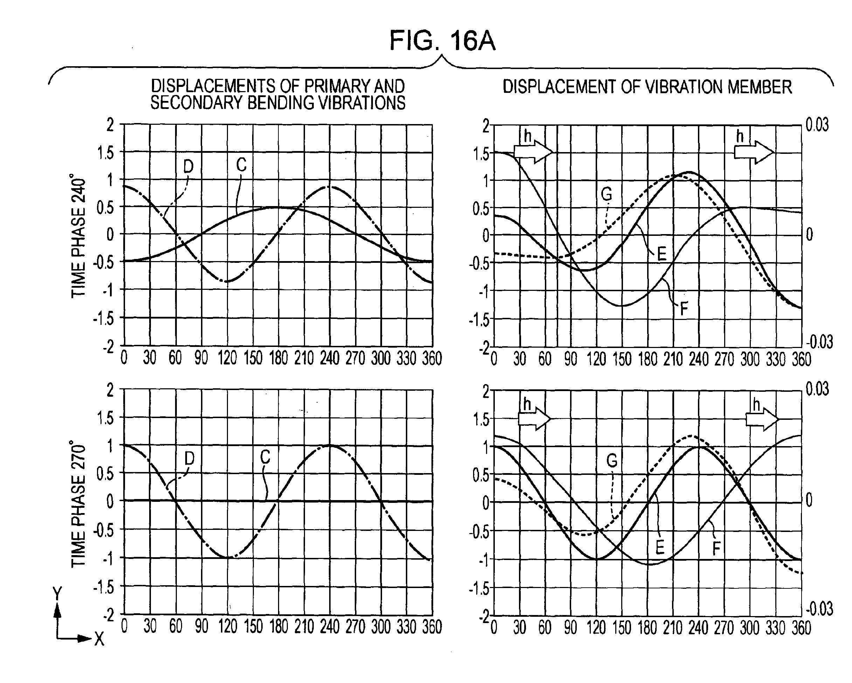

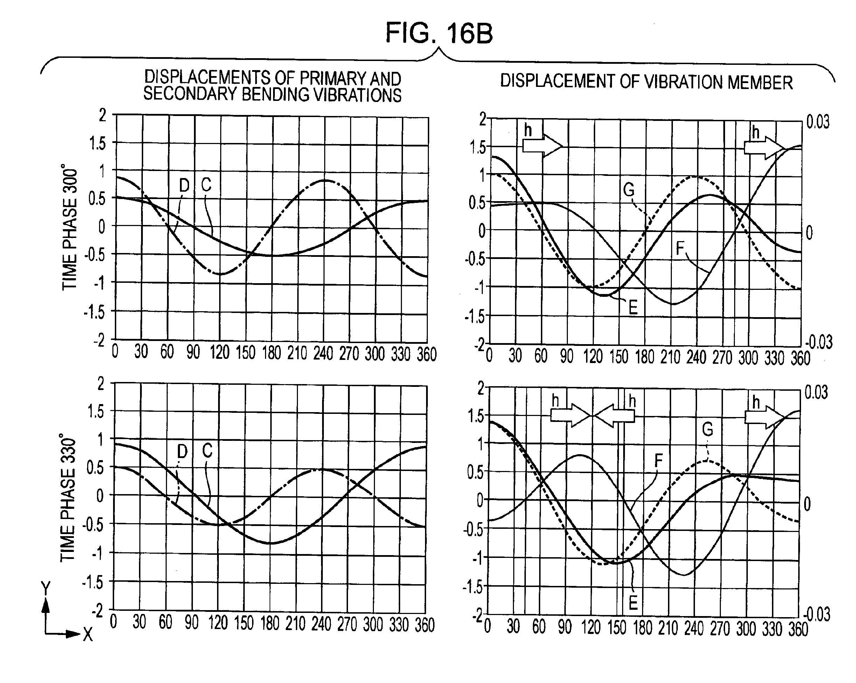

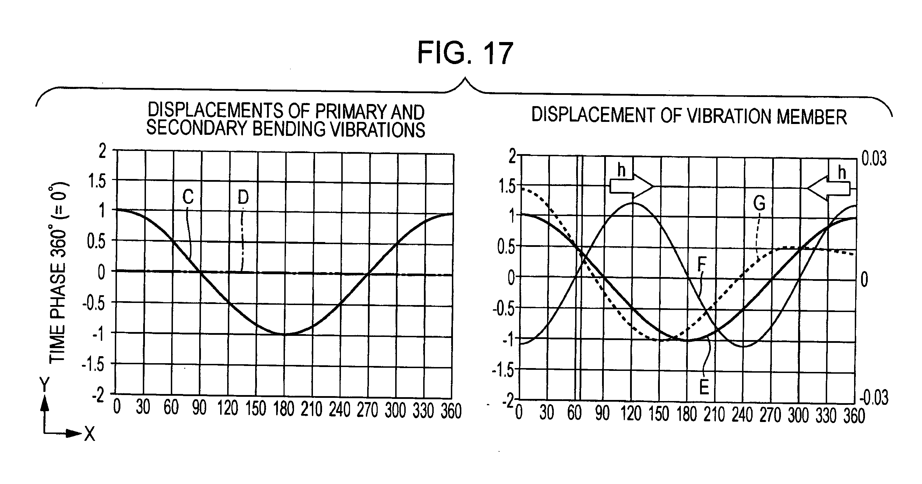

Figs. 14A, 14B, 15A, 15B, 16A, 16B and 17 are graphs depicting, at successive time phases, respective displacements of the primary out-of-plane bending vibration and the secondary out-of-plane bending vibration, as well as a displacement and a displacement speed of a vibration member in which the primary and secondary out-of-plane bending vibrations are superimposed with each other, on condition that a time phase difference between the two types of vibrations is 90° and an amplitude ratio between the two types of vibrations is 1 : 1.

In each of those graphs, the vertical axis represents the displacement and the displacement speed. A direction toward the image pickup device 301 is defined to be negative. The horizontal axis corresponds to a position in the lengthwise direction of the vibrating device 300 as in the graph of Fig. 13B.

In the graphs, a waveform C represents the displacement of the primary out-of-plane bending vibration. A waveform D represents the displacement of the secondary out-of-plane bending vibration. A waveform E represents the displacement of the vibrating device 300 (vibration member) in which those two types of out-of-plane bending vibrations are superimposed with each other. A waveform G represents the displacement of the vibrating device 300 at a time phase in advance of the waveform E by 30°. A waveform F represents the normalized displacement speed of the vibrating device 300.

With operation of the dust removing device, the dust adhering to the surface of the optical element 302 is caused to bounce and move upon receiving a force that acts in a direction normal to the surface of the optical element 302, when the optical element 302 pushes the dust away toward the out-of-plane side (i.e., in the positive direction of the vertical axis in Figs. 14A to 17).

More specifically, when the waveform F representing the displacement speed has a positive value at each time phase, the dust is pushed away toward the out-of-plane side and is caused to move by receiving the force in the normal direction, which corresponds to the waveform E representing the displacement of the vibrating device 300, at the relevant time phase. On condition that the above-mentioned displacement is given in a state where the optical element 302 is set in a posture standing at a certain angle (typically at a right angle), when the dust adhering to the surface of the optical element 302 is caused to bounce upon receiving the force acting in the direction normal to the surface of the optical element 302, the dust is dropped by gravity at a certain probability without adhering again to the surface of the optical element 302.

Each of arrows h in Figs. 14A to 17 denotes the direction in which the dust is caused to move.

Looking at Figs. 14A to 17, in the range from the position 60 to 300 of the optical element 302, an amount of vibration causing the dust to move in the positive direction of the horizontal axis is relatively greater during one period of the vibration than that causing the dust to move in the negative direction of the horizontal axis.

Accordingly, the dust can be moved in the positive direction of the horizontal axis.

Thus, when an active area (also called an optically active area) of the optical element 302 with respect to the image pickup device 301 is in the range from the position 60 to 300, the dust can be removed from the active area. Here, the term "active area" implies a zone where light incident on the image pickup device 301 passes through the optical element 302 when the optical element 302 is arranged in the optical path of the image pickup device 301.

**Citation List**

**Patent Literature**

PTL 1 Japanese Patent Laid-Open No. 2008-207170, also published as WO 2008/093884 A1. Further methods and devices are known from US 2009/0206698 A1, US 2006/0207290 A1 or US 5 001 404.

**Summary of Invention**

However, the above-described vibrating device has the following problem to be overcome.

In the vibrating device 300 disclosed in PTL 1, there are many vibration modes in the vicinity of a resonance frequency of two vibration modes that are used in the driving. When trying to excite the vibrations in the vicinity of the resonance frequency to increase the vibration modes used in the driving, other useless vibration modes are also caused to respond (namely, they are also excited or stimulated).

At node positions in the useless vibration modes where vibrations have no amplitudes (i.e., at positions where no displacements are caused), a satisfactory vibration state can be realized without being affected by the vibrations of the useless vibration modes. At other positions, however, an amplitude distribution and a phase distribution are disturbed due to influences by the vibrations in the useless vibration modes.

With such disturbance, when dust (driven object) on the surface of the optical element 302 is flipped (pushed) away toward the out-of-plane side, there may generate a position where an in-plane direction in which the object is caused to move is reversed, or a position where a component in the in-plane direction is small.

When the vibration state differing from the designed state is generated as described above, it may occur in some positions that moving directions of dusts in the plane are opposed to each other and the dusts cannot be moved, or that a force acting to move dust is smaller than a adhering force of the dust and efficiency in moving the dust is reduced.

In view of the problems described above, the present invention provides a vibration member driving method and a vibrating device, as well as a driving device, a dust removing device and an optical apparatus each including the vibrating device, which can efficiently move driven objects, including dust, in a predetermined direction by additionally taking, in the driving method, vibration responses in the useless vibration modes into consideration.

As a result of intensively conducting studies, the inventors have accomplished the present invention. According to the present invention, there is provided a vibration member driving method of applying at least two driving voltages to at least one electro-mechanical energy conversion element, which is disposed in a vibration member, and generating a plurality of standing waves, which are different in order from each other, in the vibration member with a time phase difference set between the standing waves, thereby producing a composite vibration resulting from the plurality of standing waves, wherein the driving method includes changing at least one of a voltage amplitude ratio and a time phase difference between the at least two driving voltages such that an amplitude distribution of the composite vibration is changed.

Further, according to the present invention, there is provided a vibrating device including a vibration member provided with at least one electro-mechanical energy conversion element, and a control unit configured to apply at least two driving voltages to the at least one electro-mechanical energy conversion element and to generate a plurality of standing waves, which are different in order from each other, in the vibration member with a time phase difference set between the standing waves, thereby producing a composite vibration resulting from the plurality of standing waves, wherein the control unit changes at least one of a voltage amplitude ratio and a time phase difference between the at least two driving voltages such that an amplitude distribution of the composite vibration is changed.

Still further, according to the present invention, there is provided a driving device including the vibrating device described above, and a driven member, the driven member being driven by the vibrating device.

Still further, according to the present invention, the vibrating device described above functions as a dust removing device that moves dust on the vibration member with the composite vibration, thereby removing the dust.

Still further, according to the present invention, there is provided an optical apparatus including the vibrating device described above, which includes the vibration member disposed in an optical path and which functions as a dust removing device, and an image pickup device on which light having passed through the vibration member is incident.

With the embodiments of the present invention, the driven object, including dust, can be efficiently moved in the predetermined direction with vibrations.

**Brief Description of Drawings**

Fig. 1 illustrates a camera according to a first embodiment of the present invention.
Fig. 2 illustrates a vibrating device according to the first embodiment of the present invention.
Fig. 3A is a perspective view of a deformed shape of an optical element in a first vibration mode according to the first embodiment of the present invention, and Fig. 3B is a perspective view of a deformed shape of the optical element in a second vibration mode.

Fig. 4 illustrates correspondence among respective nodal lines in the first vibration mode and the second vibration mode, layout of piezoelectric elements, and an electrode pattern according to the first embodiment of the present invention.

Fig. 5A is a graph depicting a frequency of a vibration exciting voltage versus a response gain of vibration in each vibration mode per unit voltage, and Fig. 5B is a graph depicting the frequency of the vibration exciting voltage versus a response phase of vibration in each vibration mode.

Fig. 6A is a perspective view of a deformed shape of the optical element in a third vibration mode according to the first embodiment of the present invention, and Fig. 6B illustrates the deformed shape in Fig. 6A when viewed in a first direction A. Fig. 6C is a perspective view of a deformed shape of the optical element in a fourth vibration mode according to the first embodiment of the present invention, and Fig. 6D illustrates the deformed shape in Fig. 6C when viewed in the first direction A.

Fig. 7A illustrates correspondence among a range for specifying regions, the region, and setting of alternating voltages according to the first embodiment of the present invention, Fig. 7B is a perspective view of the deformed shape of the optical element in the third vibration mode according to the first embodiment of the present invention, and Fig. 7C illustrates the deformed shape when viewed in-the first direction A, including layout of the regions.

Fig. 8 is a table denoting values of responses of vibrations in the first to fourth vibration modes, which are used in settings of respective alternating voltages according to the first embodiment of the present invention.

Fig. 9A is a table denoting values of responses of 10th- and 11th-order vibrations, which are used in settings of the respective alternating voltages according to the first embodiment of the present invention, Fig. 9B is a table denoting the magnitudes and the phases of the vibration exciting voltages, and Fig. 9C is a table denoting the magnitudes and the phases of the alternating voltages, as well as voltage magnitude ratios and time phase differences therebetween.

Fig. 10 is a table denoting values of responses of first to fourth vibrations, which are used in calculations to determine vibration states at region boundaries according to the first embodiment of the present invention.

Fig. 11 is a table denoting values of responses of 10th- and 11th-order vibrations modes, which are used in calculations to determine the vibration states at the region boundaries according to the first embodiment of the present invention.

Fig. 12A is a table denoting the vibration states at the region boundaries according to the first embodiment of the present invention, and Fig. 12B is a table denoting values of amplitude ratios and time phase differences between the 10th- and 11th-order vibrations in the vibration states.

Fig. 13A illustrates the construction of a related-art vibrating device, and Fig. 13B illustrates displacement distributions of a primary out-of-plane bending vibration and a secondary out-of-plane bending vibration of a vibration member in the related-art vibrating device, including layout of piezoelectric elements.

Figs. 14A and 14B are a set of graphs depicting, at successive time phases, respective displacements of the primary out-of-plane bending vibration and the secondary out-of-plane bending vibration and displacements of the vibration member in which those two types of vibrations are superimposed with each other, when a time phase difference between those two types of vibrations is 90° in the related-art vibrating device.

Fig. 15A and 15B are a set of graphs depicting, at successive time phases, respective displacements of the primary out-of-plane bending vibration and the secondary out-of-plane bending vibration and displacements of the vibration member in which those two types of vibrations are superimposed with each other, when a time phase difference between those two types of vibrations is 90° in the related-art vibrating device.

Figs. 16A and 16B are a set of graphs depicting, at successive time phases, respective displacements of the primary out-of-plane bending vibration and the secondary out-of-plane bending vibration and displacements of the vibration member in which those two types of vibrations are superimposed with each other, when a time phase difference between those two types of vibrations is 90° in the related-art vibrating device.

Fig. 17 is a set of graphs depicting, at successive time phases, respective displacements of the primary out-of-plane bending vibration and the secondary out-of-plane bending vibration and displacements of the vibration member in which those two types of vibrations are superimposed with each other, when a time phase difference between those two types of vibrations is 90° in the related-art vibrating device.

## Description of Embodiments

In the present invention, at least two alternating voltages are set in consideration of the vibration responses in the useless vibration modes described above. At least one of a voltage amplitude ratio and a time phase difference between the driving voltages is changed.

The term "vibration member" used in the present invention implies a member that is obtained by joining an optical element made of an elastic body and a piezoelectric element into an integral unit with an adhesive, for example.

The present invention provide a vibration member driving method practiced as described below, and a vibrating device constructed as described below, as well as a driving device, a dust removing device and an optical apparatus each including the vibrating device.

It is to be noted that the present invention is described in more detail below, but the scope of the present invention is not restricted by the following description.

## First Embodiment

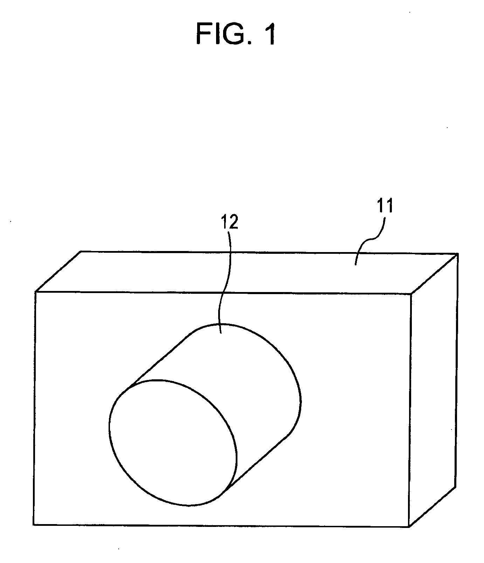

Fig. 1 illustrates a camera as one example of the optical apparatus. The camera includes a camera body 11 and a lens housing 12.

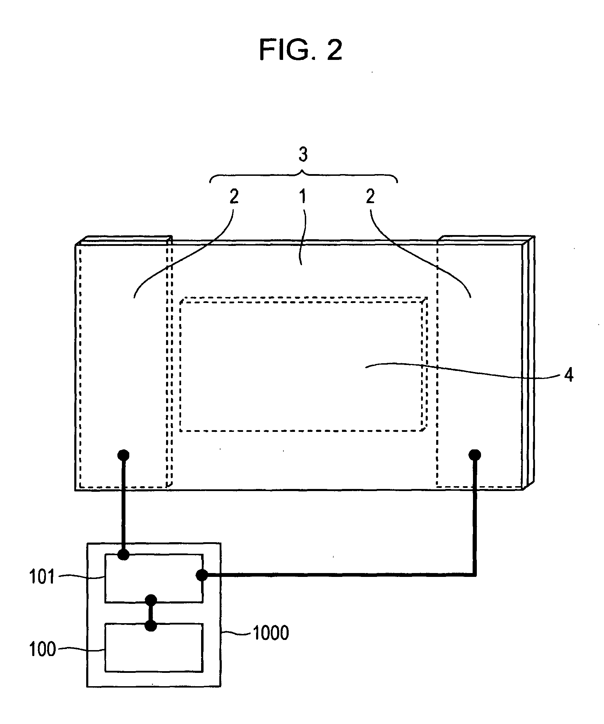

An exemplary construction of a vibrating device equipped in the camera, according to the first embodiment, is described with reference to Fig. 2.

The vibrating device according to this embodiment functions as a dust removing device for moving and removing dust. The dust removing device is disposed in an optical path of an optical apparatus.

In Fig. 2, reference numeral 1 denotes an optical element. Two electro-mechanical energy conversion elements, i.e., two piezoelectric elements 2 (2a, 2b), are fixed to the optical element 1 on the same side as an image pickup device 4 by bonding. It is to be noted that, in the present invention, the number of piezoelectric elements is not limited to two and at least one piezoelectric element is just required as in PTL 1. When a single piezoelectric element is disposed, separate electrodes may be disposed on the piezoelectric element and different driving voltages may be applied to the separate electrodes. A control circuit 100 sets frequencies, voltage values, and time phases of alternating voltages generated as driving voltages by a power supply 101. The power supply 101 is electrically connected to the piezoelectric elements 2a and 2b. A control unit 1000 is made up of the control circuit 100 and the power supply 101. At least two driving voltages are required in the present invention.

The optical element 1 and the piezoelectric elements 2 constitute a vibration member 3. The vibration member 3 is attached to the image pickup device 4 in such a manner that a space on the front side of the image pickup device 4, which serves as a light receiving element, is enclosed in a sealed-off state. Light from an object passes through the optical element 1 and enters the image pickup device 4. A zone where the light entering the image pickup device 4 passes through the optical element 1 at that time provides an optically active area 5.

In this embodiment, two types of out-of-plane bending vibrations (standing waves) having nodal lines extending in the same direction side by side and differing in order from each other are excited with a time phase difference set therebetween, thus generating in the vibration member 3 a composite vibration resulting from the two out-of-plane bending vibrations, as in the related art disclosed in PTL 1. The term "nodal line" used in the present invention implies an imaginary line formed by connecting positions that become nodes of standing waves when the standing waves are generated in a predetermined surface of a vibration object (e.g., an optical element), which is an elastic body, by applying vibration to the predetermined surface of the vibration object.

In this embodiment, the control circuit 100 sets the frequency of the driving voltages generated by the power supply 101 to cause responses in both a 10th-order out-of-plane bending vibration mode (first vibration mode) and an 11th-order out-of-plane bending vibration mode (second vibration mode) in each of which nodal lines are arranged side by side in the left-and-right direction on the drawing sheet (first direction denoted by A in the drawings) and which differ in order from each other, both the responses being substantially the same at that frequency. Herein, the term "response" implies that vibration is excited or stimulated.

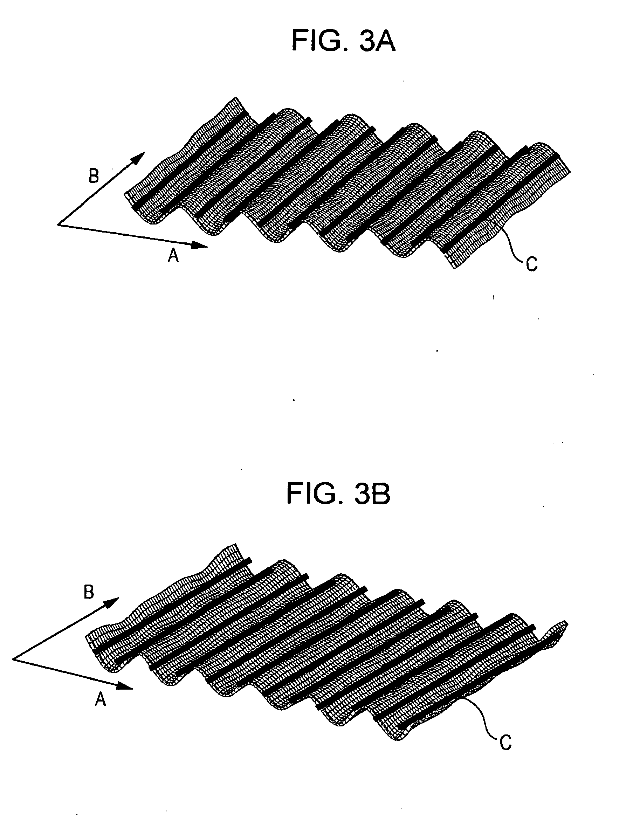

Fig. 3A is a perspective view of a deformed shape of the optical element 1 in the first vibration mode, and Fig. 3B is a perspective view of a deformed shape of the optical element 1 in the second vibration mode. In each of Figs. 3A and 3B, A denotes the first direction, and B denotes a second direction crossing the first direction.

In this embodiment, the first direction A and the second direction B are perpendicular to each other. C denotes a nodal line in the vibration mode. In each of the first vibration mode and the second vibration mode, there are plural nodal lines arranged side by side in the first direction A. The number of nodal lines arranged side by side in the first direction A is 11 in the first vibration mode, and the number of nodal lines arranged side by side in the second direction A is 12 in the second vibration mode. Thus, the number of nodal lines differs between the first vibration mode and the second vibration mode. In the first vibration mode, because the order of the out-of-plane bending deformation is lower than that in the second vibration mode and a wavelength is longer than that in the second vibration mode, a natural frequency is lower than that in the second vibration mode.

The control circuit 100 sets the time phase difference between the two driving voltages generated by the power supply 101. Thus, the 10th-order out-of-plane bending vibration mode (first vibration mode) and the 11th-order out-of-plane bending vibration mode (second vibration mode) are produced in the vibration member 3 at different time phases.

With a composite vibration resulting from those two vibration modes, in-plane directions in which driven objects such as dust are flipped away toward the out-of-plane side are the same over substantially the entire surface of the optical element 1 as in the related art (disclosed in PTL 1). Therefore, forces acting in one in-plane direction can be applied to all the driven objects, which are caused to move with the composite vibration, and movement of the driven objects in the one in-plane direction can be realized.

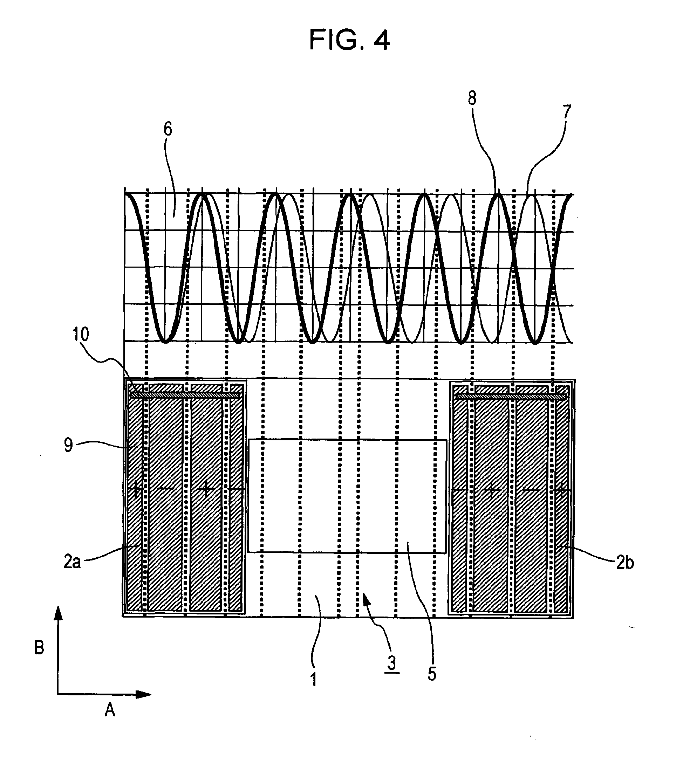

Correspondence among respective nodal lines in the 10th-order out-of-plane bending vibration mode (first vibration mode) and the 11th-order out-of-plane bending vibration mode (second vibration mode), layout of the piezoelectric elements 2, and an electrode pattern, according to the this embodiment, is described below with reference to Fig. 4.

A plot 6 depicts a displacement distribution (denoted by 7 in Fig. 4) in the first vibration mode excited in the vibration member 3, and a displacement distribution (denoted by 8 in Fig. 4) in the second vibration mode excited in the vibration member 3. The vertical axis represents a displacement of the optical element 1 toward the out-of-plane side, and the side opposite to the side where the image pickup device 4 is disposed is defined to be positive. The horizontal axis corresponds to a position along the optical element 1 in the left-and-right direction, as illustrated in Fig. 4. Further, in this embodiment, a neutral plane between the two types of bending vibrations locates inside the optical element 1.

The piezoelectric element 2 disposed at a position corresponding to a positive displacement is deformed with expansion and contraction in the left-and-right direction, and the piezoelectric element 2 disposed at a position corresponding to a negative displacement is deformed in opposite phase (180°) with expansion and contraction in the left-and-right direction. The piezoelectric elements 2a and 2b at the left and right ends, respectively, are each in the form of a rectangular plate. Each piezoelectric element 2 is disposed to cover a zone from the end of the optical element 1 to the optically active area 5 in the left-and-right direction (i.e., in the first direction A), and to cover a zone until reaching both the ends of the optical element 1 in the up-and-down direction (i.e., in the second direction B).

Each of the piezoelectric elements 2a and 2b has a uniform electrode over an entire rear surface thereof, at which the piezoelectric element is joined to the optical element 1, and also has a plurality of split electrodes (hereinafter referred to as "split electrodes 9") over a front surface thereof on the side opposite to the rear surface.

Positions at which the split electrodes 9 are split are each located at a midpoint between a position of the node where the displacement indicated by the displacement distribution 7 in the first vibration mode is substantially zero and a position of the node where the displacement indicated by the displacement distribution 8 in the second vibration mode is substantially zero, such correspondence being denoted by dotted lines in Fig. 4.

When the piezoelectric element 2 is polarized, the electrode on the rear surface is held at the ground potential, and adjacent two of the split electrodes 9 on the front surface are subjected to potentials having different polarities as denoted by "+" and "-" in Fig. 4. Polarities of "+", "-", "+", "-" are successively applied to the split electrodes 9 of the left piezoelectric element 2a from the left end, and polarities of "+", "-", "+", "-" are successively applied to the split electrodes 9 of the right piezoelectric element 2b from the right end. The polarization direction is a direction of thickness of the piezoelectric element 2 and is perpendicular to the drawing sheet of Fig. 4.

After the polarization (poling treatment), a conductive paint 10 having electrical conductivity is coated to extend over the split electrodes 9 in straddling relation. Therefore, when a voltage is applied to any one of the split electrodes 9, all the split electrodes 9 of one piezoelectric element 2 are held at the same potential.

The piezoelectric element 2 has such a characteristic that it generates a force acting to expand the piezoelectric element 2 in a direction perpendicular to the polarization direction when a potential having the same polarity as the polarity of the potential having been applied for the polarization is applied to the piezoelectric element 2, and that it generates a force acting to contract the piezoelectric element 2 when a potential having a polarity different from the polarity of the potential having been applied for the polarization is applied to the piezoelectric element 2. When an alternating voltage is applied, the piezoelectric element 2 generates periodic expanding and contracting forces in match with the period of the alternating voltage. Further, when the alternating voltage is applied, the phase (0° or 180°) of the expanding and contracting forces with respect to the alternating voltage is determined depending on the polarity having been applied for the polarization.

A driving voltage $E(1) = V(1) \times \cos(2\pi ft)$ in the form of an alternating voltage is applied to the left piezoelectric element 2a. The driving voltage E(1) is a first driving voltage in the present invention. V(1) is the magnitude (amplitude) of the applied voltage, f is a frequency, and t is a time. A driving voltage $E(2) = V(2) \times \cos(2\pi ft + \delta \times \pi/180)$ in the form of an alternating voltage, which differs in time phase from the driving voltage E(1) by $\delta$ in unit of degree, is applied to the right piezoelectric element 2b. The driving voltage E(2) is a second driving voltage in the present invention, and V(2) is the magnitude (amplitude) of the applied voltage.

On that condition, a voltage mainly contributing to the 10th-order out-of-plane bending vibration mode (first vibration mode 7), in which the piezoelectric elements 2a and 2b cause bending deformations in opposite phases, is given by E(difference) that is obtained by allocating a difference component between the driving voltages E(1) and E(2) to the left and right piezoelectric elements 2a and 2b. E(difference) is defined as E(difference) = E(1)/2 - E(2)/2.

On the other hand, a voltage mainly contributing to the 11th-order out-of-plane bending vibration mode (second vibration mode 8), in which the piezoelectric elements 2a and 2b cause bending deformations in the same phase, is given by E(sum) that is obtained by allocating a sum component of the driving voltages E(1) and E(2) to the left and right piezoelectric elements 2a and 2b. E(sum) is defined as E(sum) = E(1)/2 + E(2)/2.

Phases of the expanding and contracting forces generated in the piezoelectric elements 2 with application of E(difference) are described below on condition that E(difference) is regarded as the basis of phase. The phases of the expanding and contracting forces generated in the left piezoelectric element 2a are distributed successively in the sequence of 0°, 180°, 0° and 180° from the left end corresponding to the split electrodes 9. The phases of the expanding and contracting forces generated in the right piezoelectric element 2b are distributed successively in the sequence of 180°, 0°, 180° and 0° from the right end.

Such a phase distribution of the expanding and contracting forces substantially matches with a phase distribution of deformations due to expansion and contraction of the piezoelectric element 2, which is represented by the displacement distribution 7 in the 10th-order out-of-plane bending vibration mode (first vibration mode).

Therefore, a large vibration in the 10th-order out-of-plane bending vibration mode (first vibration mode) can be obtained.

Regarding the displacement distribution 8 in the 11th-order out-of-plane bending vibration mode (second vibration mode), however, the phase distribution of the expanding and contracting forces substantially matches with the displacement distribution 8 in the left piezoelectric element 2a, but it is substantially reversed from the displacement distribution 8 in the right piezoelectric element 2b.

Stated another way, in the 11th-order out-of-plane bending vibration mode (second vibration mode) with application of E(difference), the vibration excited by the left piezoelectric element 2a and the vibration excited by the right piezoelectric element 2b have magnitudes equal to each other and are in opposite phases. Therefore, those vibrations cancel each other and a resulting magnitude becomes almost zero. Thus, the vibration in the 11th-order out-of-plane bending vibration mode (second vibration mode) is not generated in the case of E(difference).

Further, in other vibration modes differing in the number of nodes in the left-and-right direction from the 10th-order out-of-plane bending vibration mode (first vibration mode), magnitudes of vibrations can also be reduced with an effect of canceling the vibrations each other because the phase distribution of the expanding and contracting forces differs from the phase distribution of the deformations.

Next, phases of the expanding and contracting forces generated in the piezoelectric elements 2 with application of E(sum) are described below on condition that E(sum) is regarded as the basis of phase. The phases of the expanding and contracting forces generated in the left piezoelectric element 2a are distributed successively in the sequence of 0°, 180°, 0° and 180° from the left end corresponding to the split electrodes 9. The phases of the expanding and contracting forces generated in the right piezoelectric element 2b are distributed successively in the sequence of 0°, 180°, 0° and 180° from the right end.

Such a phase distribution of the expanding and contracting forces substantially matches with a phase distribution of deformations due to expansion and contraction of the piezoelectric element 2, which is represented by the displacement distribution 8 in the 11th- order out-of-plane bending vibration mode (second vibration mode). Therefore, large vibration in the 11th-order out-of-plane bending vibration mode (second vibration mode) can be obtained.

Regarding the displacement distribution 7 in the 10th-order out-of-plane bending vibration mode (first vibration mode), however, the phase distribution of the expanding and contracting forces substantially matches with the displacement distribution 7 in the left piezoelectric element 2a, but it is substantially reversed from the displacement distribution 7 in the right piezoelectric element 2b.

Stated another way, in the 10th-order out-of-plane bending vibration mode (first vibration mode) with application of E(sum), the vibration excited by the left piezoelectric element 2a and the vibration excited by the right piezoelectric element 2b have magnitudes equal to each other and are in opposite phases. Therefore, those vibrations cancel each other and a resulting magnitude becomes almost zero. Thus, the vibration in the 10th-order out-of-plane bending vibration mode (first vibration mode) is not generated in the case of E(sum).

Further, in other vibration modes differing in the number of nodes in the left-and-right direction from the 11th-order out-of-plane bending vibration mode (second vibration mode), magnitudes of vibrations can also be reduced with an effect of canceling the vibrations each other because the phase distribution of the expanding and contracting forces differs from the phase distribution of the deformations.

The relationships among the vibration in the first vibration mode, the vibration in the second vibration mode, the driving voltage E(1), and the driving voltage E(2) are described in more detail below, taking into consideration not only the vibration exciting voltage E(difference) and the vibration exciting voltage E(sum) described above, but also a vibration response (gain of response amplitude and response phase).

Regarding the vibration response of the first vibration mode to the vibration exciting voltage E(difference), the gain of the response amplitude is defined as $\alpha(1)$ and the response phase is defined as $\beta(1)$. Similarly, regarding the vibration response of the second vibration mode to the vibration exciting voltage E(sum), the gain of the response amplitude is defined as $\alpha(2)$ and the response phase is defined as $\beta(2)$. The gains $\alpha(1)$ and $\alpha(2)$ of the response amplitude are provided as values calculated at positions where the displacements (amplitudes) are maximum in the displacement distributions in the first and second vibration modes, illustrated in Fig. 4, respectively. The positions of the maximum amplitudes are present in one-to-one relation to each wavelength, and the amplitudes at those positions have the same value.

In a distribution of the response phase in each vibration mode, the response phase takes a constant value in an area where the displacement is positive. Also, the response phase takes a constant value in an area where the displacement is negative, but it is reversed from the response phase in the area where the displacement is positive, namely it differs from the latter by 180°. Values of the response phases $\beta(1)$ and $\beta(2)$ are obtained by calculating the response phases in the area where the displacement is positive.

The values of $\alpha(1)$, $\beta(1)$, $\alpha(2)$ and P (2) are measured by using, e.g., a laser Doppler vibration meter and are provided as known values. Further, the magnitudes of the driving voltage E(1), the driving voltage E(2), the vibration exciting voltage E(difference), and the vibration exciting voltage E(sum) are defined respectively as V(1), V(2), V(difference) and V(sum), and the time phases thereof are defined respectively as $\theta(1)$, $\theta(2)$, $\theta(difference)$ and $\theta(sum)$.

Regarding the vibration in the first vibration mode, V(difference) and $\theta(difference)$ to obtain the magnitude X(1) and a time phase $\phi(1)$ are expressed by the following formulae (1) and (2), respectively. The magnitude X(1) is provided as a value of the amplitude at the position where the displacement is maximum in the displacement distribution in the first vibration mode, and the time phase $\phi(1)$ is provided as a value of the response phase in the area where the displacement is positive.

$$V(difference) = X(1)/\alpha(1) \qquad \ldots(1)$$

$$\theta(difference) = \phi(1) - \beta(1) \qquad \ldots(2)$$

Similarly, regarding the vibration in the second vibration mode, V(sum) and $\theta$ (sum) to obtain the magnitude X(2) and a time phase $\phi$(2) are expressed by the following formulae (3) and (4), respectively. The magnitude X(2) is provided as a value of the amplitude at the position where the displacement is maximum in the displacement distribution in the second vibration mode, and the time phase $\phi$(2) is provided as a value of the response phase in the area where the displacement is positive.

$$V(sum) = X(2)/\alpha(2) \qquad \ldots(3)$$

$$\theta(sum) = \phi(2) - \beta(2) \qquad \ldots(4)$$

Further, the driving voltage E(1) is provided as a value resulting from summing E(sum) and E(difference), and E(2) is provided as a value resulting from subtracting E(difference) from E(sum). V(1), $\theta$(1), V(2) and $\theta$ (2) are expressed respectively by the following formulae (5) to (8).

$$V(1) = [\{V(sum) \times \cos\theta(sum) + V(difference) \times \cos\theta(difference)\}^2 + \{V(sum) \times \sin\theta(sum) + V(difference) \times \sin\theta(difference)\}^2]^{0.5} \qquad \ldots(5)$$

$$\theta(1) = \tan^{-1}[\{V(sum) \times \sin\theta(sum) + V(difference) \times \sin\theta(difference)\} / \{V(sum) \times \cos\theta(sum) + V(difference) \times \cos\theta(difference)\}] \qquad \ldots(6)$$

$$V(2) = [\{V(sum) \times \cos\theta(sum) - V(difference) \times \cos\theta(difference)\}^2 + \{V(sum) \times \sin\theta(sum) - V(difference) \times \sin\theta(difference)\}^2]^{0.5} \qquad \ldots(7)$$

$$\theta(2) = \tan^{-1}[\{V(sum) \times \sin\theta(sum) - V(difference) \times \sin\theta(difference)\} / \{V(sum) \times \cos\theta(sum) - V(difference) \times \cos\theta(difference)\}] \qquad \ldots(8)$$

In the present invention, the vibration in the first vibration mode and the vibration in the second vibration mode are to be the same in magnitude and a time phase difference therebetween is to be 90° in order to more efficiently move dust, etc. (i.e., all objects moved with the vibrations). This corresponds to the conditions of X(1) = X(2) = X(0) and $\phi$(1) - $\phi$(2) = 90°. X(0) represents a magnitude of the amplitude that is to be previously set in view of a moving state of the object to be moved. V(1), V(2), $\theta$(1) and $\theta$(2) satisfying those conditions are determined by using the formulae (1) to (8).

X(0) can be made $\gamma$ times by multiplying each of V(1) and V(2) by $\gamma$. A voltage amplitude ratio $\varepsilon$ = V(2)/V(1) between V(1) and V(2) is not changed. Further, supposing $\theta$(1) to be the basis of time phase, the time phase difference $\delta$ is expressed by $\delta$ = $\theta$(2) - $\theta$(1). In other words, the voltage amplitude ratio $\varepsilon$ and the time phase difference $\delta$ can be calculated by using the formulae (1) to (8), a formula (9) of X(1) = X(2), and a formula (10) of $\phi$(1) - $\phi$(2) = 90° in order to more efficiently move dust, etc.

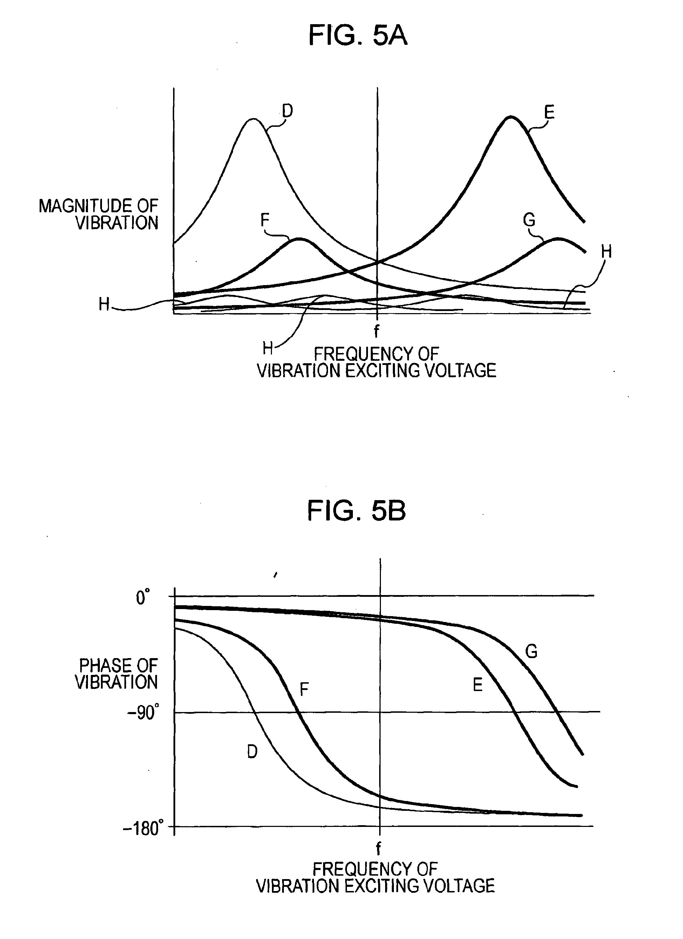

For deeper understanding of the present invention, the problem with the related art (disclosed in PTL 1) is described in more detail below. Fig. 5A is a graph depicting a frequency of the vibration exciting voltage versus a response gain of vibration in each vibration mode per unit voltage (1 V), and Fig. 5B is a graph depicting the frequency of the vibration exciting voltage versus a response phase of vibration in each vibration mode.

In Fig. 5A, a plot D represents the response gain $\alpha$(1) of the vibration in the first vibration mode when the above-described vibration exciting voltage E(difference) in the form of a alternating voltage is the unit voltage (1 V). A plot E represents the response gain $\alpha$(2) of the vibration in the second vibration mode when the above-described vibration exciting voltage E(sum) in the form of a alternating voltage is the unit voltage (1 V). In Fig. 5B, a plot D represents the response phase $\beta$(1) of the vibration in the first vibration mode with respect to E(difference). A plot E represents the response phase $\beta$(2) of the vibration in the second vibration mode with respect to E(sum).

In the vibration member 3, there are, near the natural frequencies of the above-mentioned vibration modes, other many vibration modes (denoted by plots F, G and H in Fig. 5A).

Those other vibration modes are ones, which differ in displacement distribution from the first vibration mode D and the second vibration mode E, and which change the amplitude distributions and the phase distributions of the vibrations generated.

The vibration mode depicted by the plot F in Fig. 5A is one (third vibration mode F) that causes not only the 10th-order out-of-plane bending deformation having the same number of bending order in the left-and-right direction (first direction A) as that in the first vibration mode D, but also the primary out-of-plane bending deformation in the up-and-down direction (second direction B). The third vibration mode F has a maximum value of the response gain at a center and upper and lower ends in the up-and-down direction (second direction B). The plot F in Fig. 5A represents the magnitude when E(difference) providing the maximum value of the response gain is the unit voltage (1V). The plot F in Fig. 5B represents the response phase of the vibration in the third vibration mode with respect to E(difference).

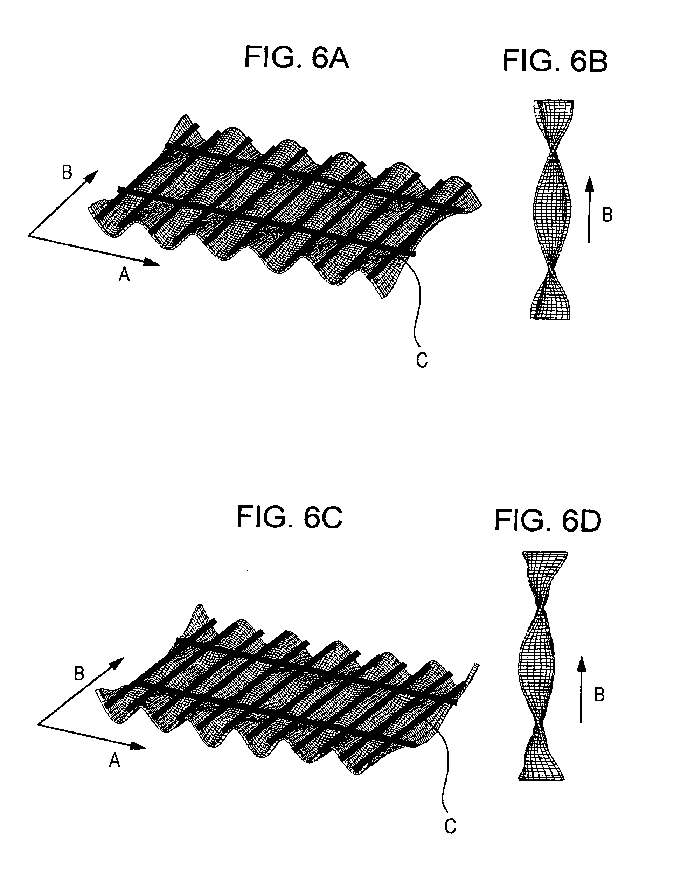

Fig. 6A is a perspective view of a deformed shape of the optical element 1 in the third vibration mode F, and Fig. 6B illustrates the deformed shape in Fig. 6A when viewed in the first direction A.

The deformed shape in the third vibration mode F includes a deformation in the up-and-down direction (second direction B) in addition to the deformed shape in the first vibration mode D. Therefore, the third vibration mode F has a somewhat higher natural frequency than that of the first vibration mode D.

Among many useless vibration modes, the vibration in the third vibration mode F is particularly increased.

The reason why the vibration in the third vibration mode F is particularly increased is as follows. In order to generate the vibration in the first vibration mode D and the vibration in the second vibration mode E, the driving voltages are applied to the piezoelectric elements 2a and 2b to generate the expanding and contracting forces in the left-and-right direction (i.e., the first direction A), thereby causing bending deformation forces in the vibration member 3.

As described above, the split positions of the split electrodes 9 are located near the positions of the nodal lines in the first vibration mode D and the second vibration mode E.

Also, in the third vibration mode F, the phase distribution of expanding and contracting deformations in the first direction A is close to the phase distribution of the expanding and contracting forces generated by the piezoelectric elements 2.

Therefore, the vibration in the third vibration mode F is increased. Further, because in the piezoelectric element 2 the up-and-down direction (second direction B) is perpendicular to the polarization direction, the expanding and contracting forces are generated in the up-and-down direction (second direction B) as well, thereby generating bending deformation forces in the vibration member 3.

Thus, in the third vibration mode F, the bending deformation is generated in the up-and-down direction (second direction B) as well. Accordingly, the vibration in the third vibration mode F is further increased.

The vibration mode having the magnitude of vibration depicted by the plot G in Fig. 5A is one (fourth vibration mode) that causes not only the 11th-order out-of-plane bending deformation having the same number of bending order in the left-and-right direction (first direction A) as that in the second vibration mode E, but also the primary out-of-plane bending deformation in the up-and-down direction (second direction B). Hence, a vibration in the fourth vibration mode G is also particularly increased. The fourth vibration mode has a maximum value of the response gain at a center and upper and lower ends in the up-and-down direction (second direction B). The plot G in Fig. 5A represents the magnitude when E(sum) providing the maximum value of the response gain is the unit voltage (1 V). The plot G in Fig. 5B represents the response phase of the vibration in the fourth vibration mode with respect to E(sum).

Fig. 6C is a perspective view of a deformed shape of the optical element 1 in the fourth vibration mode G, and Fig. 6D illustrates the deformed shape in Fig. 6C when viewed in the first direction A.

The deformed shape in the fourth vibration mode G includes a deformation in the up-and-down direction (second direction B) in addition to the deformed shape in the second vibration mode E. Therefore, the fourth vibration mode G has a somewhat higher natural frequency than that of the second vibration mode E.

The third vibration mode F and the fourth vibration mode G differ in displacement distribution in the up-and-down direction (second direction B) from the first vibration mode D and the second vibration mode E which are excited to move dust, etc. Therefore, if the vibrations in the third vibration mode F and the fourth vibration mode G are large, the amplitude distributions and the phase distributions of the vibrations for moving the dust, etc. are changed. Further, there occur positions where the dust cannot be moved or where a force moving the dust is small. The efficiency in moving the dust is thus reduced.

Responses in the amplitude distribution and the phase distribution are described below in consideration of respective responses of the vibrations in the third vibration mode and the fourth vibration mode, which vibrations are particularly increased. At the positions of nodal lines C in Figs. 6A and 6C, the amplitudes of the vibrations in the third vibration mode and the fourth vibration mode are zero. At those positions, therefore, no influences are caused by the vibrations in the third vibration mode and the fourth vibration mode. However, at other positions, influences are caused because the vibrations in the third vibration mode and the fourth vibration mode have amplitudes at the other positions.

In each of the first vibration mode and the third vibration mode, the displacement distribution in the left-and-right direction (first direction A) is provided by the 10th-order out-of-plane bending. A composite vibration resulting from the vibrations in the first vibration mode and the third vibration mode is defined as a 10th-order vibration. The magnitude of the 10th-order vibration is defined as $X(10, b)$, and the time phase thereof is defined as $\phi(10, b)$. Further, regarding the third vibration mode, the gain of the response magnitude is defined as $\alpha(3, b)$, and the response phase is defined as $\beta(3, b)$. In the third vibration mode, the response amplitude and the response phase have distributions in the second direction B. Note that b in ( ) denotes a position in the second direction B, and that $\alpha(3, b)$ and $\beta(3, b)$ are each a function of the position b. Further, because, in the 10th-order vibration, the response amplitude and the response phase have distributions in the second direction B, $X(10, b)$ and $\phi(10, b)$ are also each a function of b in ( ), which denotes the position in the second direction B.

The gain $\alpha(3, b)$ of the response amplitude is provided as a value calculated at a position where the displacement is maximum in the displacement distribution in the third vibration mode with respect to the position b. The position of the maximum amplitude is present in one-to-one relation to each wavelength in the first direction A, and the amplitudes at those positions have the same value. In a distribution of the response phase in the third vibration mode, the response phase takes a constant value in an area where the displacement is positive at the same position b. Also, the response phase takes a constant value in an area where the displacement is negative, but it is reversed from the response phase in the area where the displacement is positive, namely it differs from the latter by 180°. A value of the response phase $\beta(3, b)$ is obtained by calculating the response phase in the area where the displacement is positive at the position b. Further, regarding the composite vibration resulting from the vibration in the first vibration mode and the vibration in the third vibration mode, the gain of the response magnitude with respect to E(difference) is defined as $\alpha(10, b)$ and the response phase is defined as $\beta(10, b)$. Thus, $\alpha(10, b)$ and $\beta(10, b)$ are each a function of the position b in the second direction B.

The values of $\alpha(10, b)$ and $\beta(10, b)$ are measured by using, e.g., a laser Doppler vibration meter in a state where only E(difference) is applied, and are provided as known values. Further, the position of the node where the response gain in the third vibration mode is zero can be specified by performing a mode analysis with a numerical analysis using the finite element method. At that node position, because there is no influence of the third vibration mode, the gain $\alpha(1)$ of the response amplitude and the response phase $\beta(1)$ of the vibration in the first vibration mode can be measured with the above-described measurement. The first vibration mode provides the same response in the second direction B. The values of $\alpha(3, b)$ and $\beta(3, b)$ can be provided as known values by performing mathematical vector decomposition of $\alpha(1)$ and $\beta(1)$ based on the measured $\alpha(10, b)$ and $\beta(10, b)$.

The magnitude $X(10, b)$ and the time phase $\phi(10, b)$ of the 10th-order vibration are expressed by the following formulae (11) to (14).

$$X(10, b) = \alpha(10, b) \times V(\text{difference}) \qquad \ldots(11)$$

$$\alpha(10,\ b)\ =\ [\{\alpha(1)\ \times\ \sin\theta(1)\ +\ \alpha(3,\ b)\ \times\ \sin\theta(3,\ b)\}^2\ +$$

$$\{\alpha(1)\ \times\ \cos\theta(1)\ +\ \alpha(3,\ b)\ \times\ \cos\theta(3,\ b)\}^2]^{0.5}\quad ...(12)$$

$$\phi(10,\ b)\ =\ \beta(10,\ b)\ +\ \theta(\text{difference})\qquad ...(13)$$

$$\beta(10,\ b)\ =\ \tan^{-1}[\{\alpha(1)\ \times\ \sin\theta(1)\ +\ \alpha(3,\ b)\ \times\ \sin\theta(3,\ b)\}$$

$$/\ \{\alpha(1)\ \times\ \cos\theta(1)\ +\ \alpha(3,\ b)\ \times\ \cos\theta(3,\ b)\}]\quad ...(14)$$

Similarly, in each of the second vibration mode and the fourth vibration mode, the displacement distribution in the left-and-right direction (first direction A) is provided by the 11th-order out-of-plane bending. A composite vibration resulting from the vibrations in the second vibration mode and the fourth vibration mode is defined as an 11th-order vibration. The magnitude of the 11th-order vibration is defined as X(11, b), and the time phase thereof is defined as $\phi(11, b)$. Further, regarding the fourth vibration mode, the gain of the response magnitude is defined as $\alpha(4, b)$, and the response phase is defined as $\beta(4, b)$. In each of the fourth vibration mode and the 11th-order vibration, the response amplitude and the response phase have distributions in the second direction B. Note that b in ( ) denotes a position in the second direction B, and that $\alpha(4, b)$, $\beta(4, b)$, X(11, b) and $\phi(11, b)$ are each a function of the position b. $\alpha(4, b)$, $\beta(4, b)$, $\alpha(11, b)$ and $\beta(11, b)$ are defined similarly to $\alpha(3, b)$, $\beta(3, b)$, $\alpha(10, b)$ and P(10, b) that have been described above. The values of $\alpha(2)$, $\beta(2)$, $\alpha(4, b)$, $\beta(4, b)$, $\alpha(11, b)$ and $\beta(11, b)$ can be provided as known values, for example, by measuring them with the laser Doppler vibration meter in the state where only E(sum) is applied, or by utilizing the result of a mode analysis, or by performing vector decomposition.

The magnitude X(11, b) and the time phase $\phi(11, b)$ of the 11th-order vibration are expressed by the following formulae (15) to (18).

$$X(11,\ b)\ =\ \alpha(11,\ b)\ \times\ V(\text{sum})\qquad ...(15)$$

$$\alpha(11,\ b)\ =\ [\{\alpha(2)\ \times\ \sin\theta(2)\ +\ \alpha(4,\ b)\ \times\ \sin\theta(4,\ b)\}^2\ +$$

$$\{\alpha(2)\ \times\ \cos\theta(2)\ +\ \alpha(4,\ b)\ \times\ \cos\theta(4,\ b)\}^2]^{0.5}\quad ...(16)$$

$$\phi(11,\ b)\ =\ \beta(11,\ b)\ +\ \theta(\text{sum})\qquad ...(17)$$

$$\beta(11,\ b)\ =\ \tan^{-1}[\{\alpha(2)\ \times\ \sin\theta(2)\ +\ \alpha(4,\ b)\ \times\ \sin\theta(4,\ b)\}$$

$$/\ \{\alpha(2)\ \times\ \cos\theta(2)\ +\ \alpha(4,\ b)\ \times\ \cos\theta(4,\ b)\}]\quad ...(18)$$

As in the above-described case where only the first vibration mode and the second vibration mode are taken into consideration, the voltage amplitude ratio $\varepsilon$ and the time phase difference $\delta$ between E(1) and E(2), which are adapted to more efficiently move dust, etc., are to be calculated and set by using the formulae (11) to (18), the formulae (5) to (8), a formula (19) of X(0) = X(10, b) = X(11, b), and a formula (20) of $\phi(10, b) - \phi(11, b) = 90°$ in order to more efficiently move dust, etc. X(0) represents a magnitude of the amplitude that is to be previously set in view of a moving state of the object to be moved.

In the related art (disclosed in PTL 1), the applied driving voltages are set in consideration of only the vibrations in two vibration modes (corresponding to the first vibration mode and the second vibration mode), which are mainly excited. In other words, responses in other vibration modes are also caused, but those responses are not taken into consideration in the related art. Although it is stated in the related art that voltage setting is modified to change the direction in which dust is to be moved, just one combination of the two driving voltages is set when the direction in which dust is to be moved is the same. Thus, when the direction in which dust is to be moved is the same, the time phase difference between the two driving voltages is set as a certain particular combination. Of course, the voltage amplitude ratio between the two driving voltages is also set as a certain particular combination. Accordingly, the optimum vibration state is obtained only in the vicinity of the position corresponding to the nodal lines where the amplitudes in the third vibration mode and the fourth vibration mode are both zero, and an ability of moving dust is low in other positions. Stated another way, the amplitude distribution of the composite vibration generated in the vibration member is not changed and remains constant.

In the present invention, responses of vibrations in useless vibration modes, e.g., the third vibration mode and the fourth vibration mode, are also taken into consideration to more efficiently move dust, etc. over a wider zone.

Vibration responses, a driving method, and a beneficial effect according to the first embodiment are described below.

The frequencies of the driving voltages E(1) and E(2) are set to a frequency, denoted by f in Fig. 5A, at which the vibrations in the first and second vibration modes have the same magnitude when the magnitudes of E(difference) and E(sum) are the same. When the frequencies of E(1) and E(2) are f, the frequencies of E(difference) and E(sum) are also f.

At the frequency f, a maximum value of the magnitude of the vibration in the third vibration mode F is a half of that of the vibrations in the first and second vibration modes. Further, a maximum value of the magnitude of the vibration in the fourth vibration mode G is a quarter of that of the vibrations in the first and second vibration modes.

When the magnitudes of the vibrations in the third and fourth vibration modes are normalized on the basis of the magnitude of the vibration in the first vibration mode, a maximum value of $\alpha(3, b)$ is 0.5 and a maximum value of $\alpha(4, b)$ is 0.25 on condition of $\alpha(1) = 1$ and $\alpha(2) = 1$.

Further, the response phase $\beta(1)$ of the first vibration mode D with respect to E(difference) is -165°, and the response phase $\beta(2)$ of the second vibration mode E with respect to E(sum) is -15°. The response phase $\beta(3, b)$ of the third vibration mode F with respect to E(difference) is - 157° in a region sandwiched between two nodal lines C parallel to the first direction A in Fig. 6A and is reversed to 23° outside that region.

The response phase $\beta(4, b)$ of the fourth vibration mode G with respect to E(sum) is -12° in a region sandwiched between two nodal lines C parallel to the first direction A in Fig. 6C and is reversed to 168° outside that region.

The detailed voltage setting and vibration states in the related art are described below.

The formulae (1) to (10), the values of $\alpha(1)$ and $\alpha(2)$, and the values of $\beta(1)$ and $\beta(2)$ are used to calculate the voltage amplitude ratio $\varepsilon$ and the time phase difference $\delta$ in the voltage setting.

By substituting $\alpha(1) = 1$ in the formula (1), V(difference) = X(1) is obtained. By substituting $\alpha(2) = 1$ in the formula (3), V(sum) = X(2) is obtained. From those results and the formula (9), V(difference) = V(sum) is obtained.

By substituting $\beta(1)$= -165° in the formula (2), $\theta$ (difference) = $\phi(1)$ + 165° is obtained. By substituting $\beta(2)$= -15° in the formula (4), $\theta(sum) = \phi(2)$ + 15° is obtained. From those results and the formula (10), $\theta(difference) - \theta(sum) = 240°$ is obtained. Supposing $\theta(difference) = 0°$ with $\theta(difference)$ regarded as the basis of time phase, $\theta(sum) = -240°$ is obtained.

By substituting V(difference) = V(sum), $\theta(difference) = 0°$, and $\theta(sum) = -240°$ in the formulae (5) to (8), V(1) = V(difference), V(2) = 1.732 x V(difference), $\theta(1) = 60°$, and $\theta(2) = 150°$ are obtained. From those results, the voltage amplitude ratio $\varepsilon$ = V(2)/V(1) = 1.732 and the time phase difference $\delta$ = 90° are set. When the voltage amplitude ratio $\varepsilon$ and the time phase difference $\delta$ have those values, the vibration in the first vibration mode and the vibration in the second vibration mode come into the vibration states where their magnitudes are the same and the time phase difference therebetween is 90°. For example, given that a magnitude of the amplitude to be set is X(0) = 100, the voltage setting is provided by V(1) = 100 and V(2) = 173.2, and the time phase difference $\delta$ between E(2) and (1) is provided by $\delta$ = 90°. The vibration states are expressed by X(0) = X(1) = X(2) = 100 and $\phi(1) - \phi(2) = 90°$.

However, because there are influences of the vibrations in the third and fourth vibration modes as described above, the 10th-order vibration and the 11th-order vibration are not held in the states where the magnitudes are the same and the time phase difference is 90°, at positions other than the positions corresponding to the nodal lines of the vibrations in the third and fourth vibration modes.

Responses of the 10th-order vibration and the 11th-order vibration at the center and the upper and lower ends in the up-and-down direction (second direction B) under the same voltage setting are described below as an example.

The responses of the 10th-order vibration and the 11th-order vibration at the center in the up-and-down direction (second direction B) are determined from the formulae (11) to (14), V(difference) = V(sum), 0(difference) = 0°, $\theta(sum)$ = -240°, $\alpha(3, b)$ = 0.5, $\beta(3, b)$ = -165°, $\alpha(4, b)$ = 0.25, and $\beta(4, b)$ = -12°. As a result, X(10, b) = 150, $\phi(10, b)$ = -162°, X(11, b) = 125, and $\phi(11, b)$ = -254° are obtained. Thus, the magnitudes of X(10, b) and X(11, b) are not the same, and the time phase difference between $\phi(10, b)$ and $\phi(11, b)$ are not 90°. In other words, the ability of moving dust is reduced.

Further, X(10, b) and X(11, b) greatly differ from the magnitude of the amplitude to be set, i.e., from X(0) = 100.

Similarly, the responses of the 10th-order vibration and the 11th-order vibration at the upper and lower ends in the up-and-down direction (second direction B) are determined from the formulae (11) to (14), V(difference) = V(sum), $\theta$(difference) = 0°, $\theta$(sum) = -240°, $\alpha$(3, b) = 0.5, $\beta$(3, b) = -165°, $\alpha$(4, b) = 0.25, and $\beta$(4, b) = -12°. As a result, X(10, b) = 51, $\phi$(10, b) = -173°, X(11, b) = 75, and $\phi$(11, b) = -256° are obtained. Thus, the magnitudes of X(10, b) and X(11, b) are not the same, and the time phase difference between $\phi$(10, b) and $\phi$(11, b) are not 90°. In other words, the ability of moving dust is reduced. Further, X(10, b) and X(11, b) greatly differ from the magnitude of the amplitude to be set, i.e., from X(0) = 100.

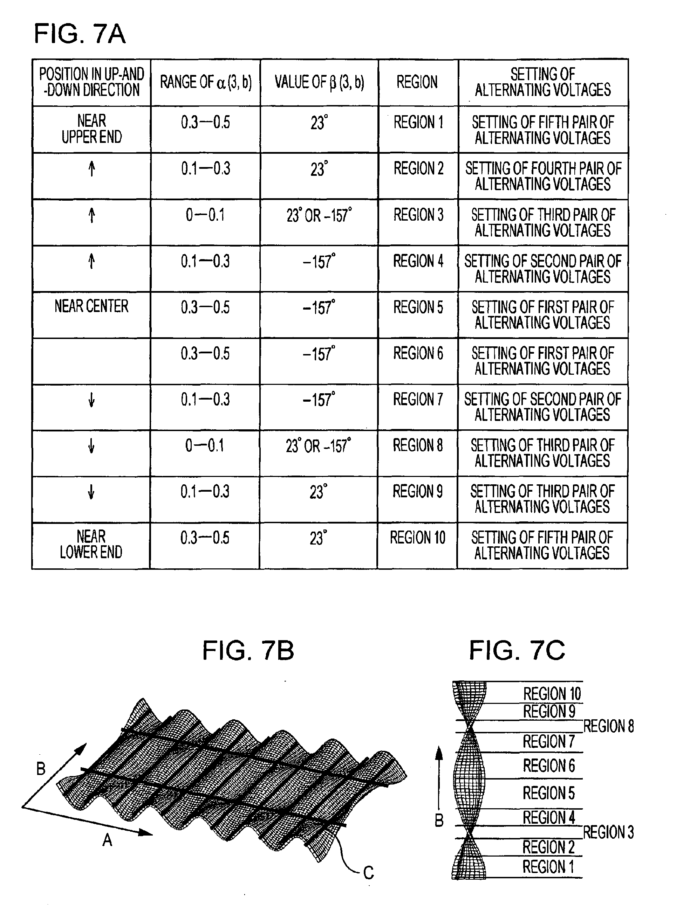

In this embodiment, the control unit changes the voltage amplitude ratio $\varepsilon$ and the time phase difference $\delta$ between the driving voltages E(1) and E(2) in consideration of the responses (excitation/stimulation) of the vibration s in the third vibration mode and the fourth vibration mode as well, which are particularly increased. Stated another way, the voltage amplitude ratio $\varepsilon$ and the time phase difference $\delta$ between the driving voltages E(1) and E(2) are changed in time series in units of a predetermined time. The responses of the vibrations in the third and fourth vibration modes have, as described above, distributions in the second direction B. Taking those distributions in the second direction B into consideration, as illustrated in Fig. 7A, the optical element 1 is imaginarily divided into 10 regions (regions 1 to 10) in the up-and-down direction (second direction B) on the basis of thresholds that are defined as the gain $\alpha$(3, b) of the response amplitude and the response phase $\beta$(3, b) of the vibration in the third vibration mode. Fig. 7B is a perspective view of the deformed shape of the optical element 1 in the third vibration mode, and Fig. 7C illustrates the deformed shape when viewed in the first direction A, including layout of the regions 1 to 10.

In the present invention, in view of the presence of optimum setting of the alternating voltages for each of the regions 1 to 10, at least one of the voltage amplitude ratio and the time phase difference between the driving voltages is changed such that the amplitude distribution of the composite vibration is changed. With the driving voltages changed so, the regions in each of which an optimum vibration state is obtained are successively changed over in time series. Thus, it is ideally realized that all the regions are successively subjected to the optimum vibration state during one control cycle.

The distributions of the gain of the response amplitude and the response phase in the first to fourth vibration modes are each symmetrical in the up-and-down direction. Accordingly, as illustrated in Fig. 7A, the regions 1 to 10 and the setting of the alternating voltages are combined such that symmetrical ones among the regions 1 to 10 in the up-and-down direction are classified as one group of regions where the same pair of alternating voltages is set (applied). Further, first to fifth pairs of alternating voltages are set respectively for five groups of regions in each of which the same pair of alternating voltages is set. Thus, in the present invention, the "region where the same pair of alternating voltages is set" is not limited to a region that physically continues over a certain span. In other words, even when regions are positioned physically away from each other, the regions can be each the "region where the same pair of alternating voltages is set" if the same pair of alternating voltages is set to those regions. Therefore, when the "region where the same pair of alternating voltages is set" is separately expressed by "a first region where the same pair of alternating voltages is set" and "a second region where the same pair of alternating voltages is set", each of the first and second regions may form one region that physically continues over a certain span. Alternatively, at least one of those regions may be a set of regions that are physically away from each other. Further, the same pair of alternating voltages is set to one or more regions belonging to one of the first region and the second region, and setting of the alternating voltages applied to the first region differs from setting of the alternating voltages applied to the second region.

In the present invention, the beneficial effect with the present invention can be obtained when the set (imaginarily divided) regions are present at least two. However, the number of the set (imaginarily divided) regions is not limited to two, and the optical element 1 may be set (imaginarily divided) to three or more regions depending on the state of the vibration to be set. Stated another way, the vibration member is imaginarily divided into first to n-th (n is an integer equal to or greater than 2) regions, and optimum setting of the alternating voltages is for each of the regions.

Further, a region setting (dividing) manner is appropriately determined on the basis of the state of the vibration to be set and the shape of a vibration object. For example, when the vibration object is rectangular, the vibration object can be divided in a direction perpendicular to the lengthwise direction of the vibration object to set a plurality of linear regions. The vibration object can also be divided in a direction parallel to the lengthwise direction of the vibration object to set a plurality of linear regions. Alternatively, the vibration object may be divided in directions perpendicular and parallel to the lengthwise direction of the vibration object to set a plurality of linear regions in a lattice pattern. When the vibration object is circular, a plurality of linear regions can be set as in the case of the rectangular vibration object. Alternatively, a plurality of concentric regions may be set.

In this embodiment, the region 5 and the region 6 are both defined as a first region where a first pair of alternating voltages is set as the same alternating voltages. Similarly, the region 4 and the region 7 are both defined as a second region where a second pair of alternating voltages is set as the same alternating voltages. Similarly, the region 3 and the region 8 are both defined as a third region where a third pair of alternating voltages is set as the same alternating voltages. Similarly, the region 2 and the region 9 are both defined as a fourth region where a fourth pair of alternating voltages is set as the same alternating voltages. Similarly, the region 1 and the region 10 are both defined as a fifth region where a fifth pair of alternating voltages is set as the same alternating voltages. Further, the first to fifth pairs of alternating voltages differ in value of at least one of the voltage amplitude ratio and the time phase difference from each other.

In the control unit in the present invention, an optimum pair of alternating voltages is set for each of the first to fifth regions such that an optimum vibration state is realized for each of the first to fifth regions in turn. Correspondence between the regions and the setting of the alternating voltages is indicated in Fig. 7A. The first pair of alternating voltages is set to provide the optimum vibration state in the first region. The second pair of alternating voltages is set to provide the optimum vibration state in the second region. The third pair of alternating voltages is set to provide the optimum vibration state in the third region. The fourth pair of alternating voltages is set to provide the optimum vibration state in the fourth region. The fifth pair of alternating voltages is set to provide the optimum vibration state in the fifth region. In the above description, the "setting of the first pair of alternating voltages" implies "combination" of the alternating voltages that are applied, when there are two piezoelectric elements, to a first piezoelectric element and a second piezoelectric element, respectively, in order to obtain the optimum vibration state in the "first region". Thus, the first pair of alternating voltages is set in terms of a voltage amplitude ratio (first voltage amplitude ratio) and a time phase difference (first time phase difference) between the alternating voltages applied respectively to the first piezoelectric element and the second piezoelectric element. Similarly, the second pair of alternating voltages is set in terms of a second voltage amplitude ratio and a second time phase difference. Similarly, the third to fifth pairs of alternating voltages are set respectively in terms of third to fifth voltage amplitude ratios and third to fifth time phase differences. In other words, the setting of the n-th pair of alternating voltages corresponding to the n-th region is expressed in terms of a voltage amplitude ratio (n-th voltage amplitude ratio) and a time phase difference (n-th time phase difference) between the alternating voltages.

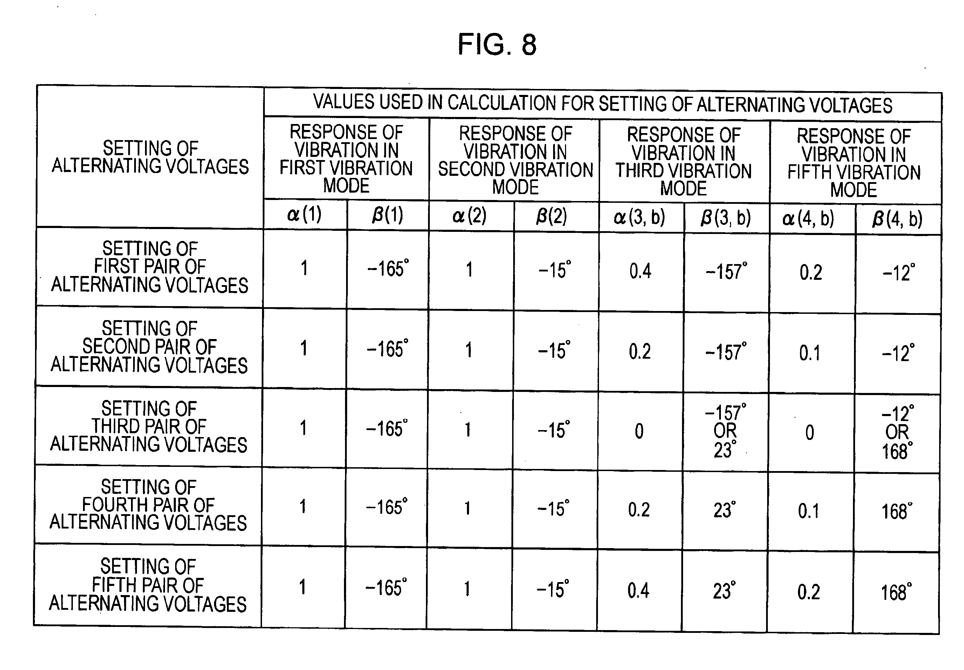

Values listed in Fig. 8 are used in calculations for setting the alternating voltages. In calculations for setting each pair of the alternating voltages, an intermediate value of $\alpha(3, b)$ in the relevant region is used. The responses of the vibrations in the first and second vibration modes are uniform in the up-and-down direction (second direction B). In all of the regions, therefore, $\alpha(1) = 1$, $\alpha(2) = 1$, $\beta(1) = -165°$, and $\beta(2) = -15°$ are provided. For the region 5 and the region 6 belonging to the first region where the first pair of alternating voltage is set, $\alpha(3, b)$ is in the range of 0.3 to 0.5 and an intermediate value 0.4 is used. Similarly, an intermediate value in the range of $\alpha(3, b)$ is used in setting the other pairs of alternating voltages. The value of $\beta(3, b)$ is -157° in the region sandwiched between two nodal lines C parallel to the first direction A in Fig. 7B and is 23° outside that region. Correspondingly, the value of $\beta(3, b)$ is set as indicated in Fig. 8. A value for the setting of the alternating voltages in the region 3 and the region 8, each belonging to the third region where the third pair of alternating voltages is set, is indicated as -157° or 23° in Fig. 8. However, such a value for the setting is practically meaningless because the gain $\alpha(3, b)$ of the response amplitude, which is used in the third region, is zero.

Since the displacement distribution in the up-and-down direction (second direction B) in the fourth vibration mode is the same as that in the third vibration mode, $\alpha(4, b) \propto \alpha(3, b)$ is held. Both $\alpha(3, b)$ and $\alpha(4, b)$ have maximum values at the center and the upper and lower ends in the up-and-down direction (second direction B). The maximum value of the former is 0.5, and the maximum value of the latter is 0.25. Therefore, $\alpha(4, b) = 0.5 \times \alpha(3, b)$ is held. The value of $\beta(4, b)$ is -12° in the region sandwiched between two nodal lines C parallel to the first direction A in Fig. 7B and is 168° outside that region. Correspondingly, the value of $\beta(4, b)$ is set as indicated in Fig. 8. A value for the setting of the alternating voltages in the region 3 and the region 8, each belonging to the third region where the third pair of alternating voltages is set, is indicated as -12° or 168° in Fig. 8. However, such a value for the setting is practically meaningless because the gain $\alpha(4, b)$ of the response amplitude, which is used in the third region, is zero.

Values used in setting the alternating voltages are calculated by using the values indicated in Fig. 8 and the formulae (5) to (8) and (11) to (20) on condition of X(0) = 100 as in the above-described detailed voltage setting in the related art.

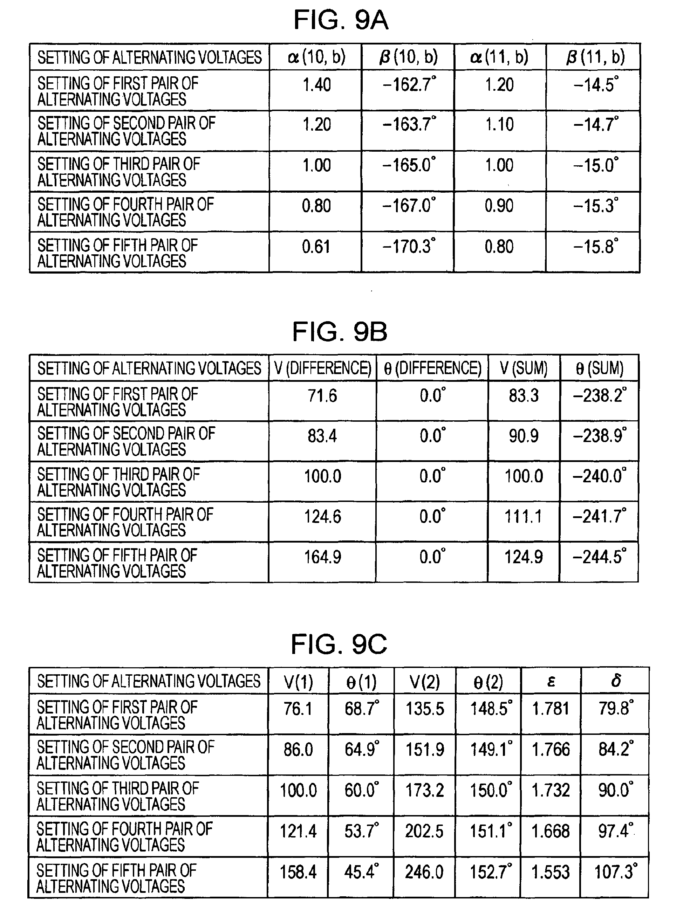

From the values indicated in Fig. 8 and the formulae (12), (14), (16) and (18), values of $\alpha(10, b)$, $\beta(10, b)$, $\alpha(11, b)$ and $\beta(11, b)$ used in setting the respective pairs of alternating voltages are provided as indicated in Fig. 9A. From the values indicated in Fig. 9A and the formulae (11), (13), (15), (17), (19) and (20), V(difference), θ(difference), V(sum), and θ(sum) are provided as indicated in Fig. 9B. From the values indicated in Fig. 9B and the formulae (5) to (8), V(1), θ(1), V(2), and θ(2) are provided as indicated in Fig. 9C. Values of the voltage amplitude ratio ε and the time phase difference δ are also indicated in Fig. 9C. The first to fifth voltage amplitude ratios ε differ from one another. Also, the first to fifth time phase differences δ differ from one another.

The vibration states in the regions corresponding to the settings of the respective pairs of alternating voltages are described below.

At the position in each of the regions which position has been used in the calculation for setting of the corresponding alternating voltages, X(10) = X(11) = X(0) = 100 and $\phi(1) - \phi(2) = 90°$ are obtained. Thus, the optimum vibration state is realized. As departing away from that position, the vibration state is gradually worsened within the region and then becomes worst at a boundary between the regions (hereinafter referred to as a "region boundary").

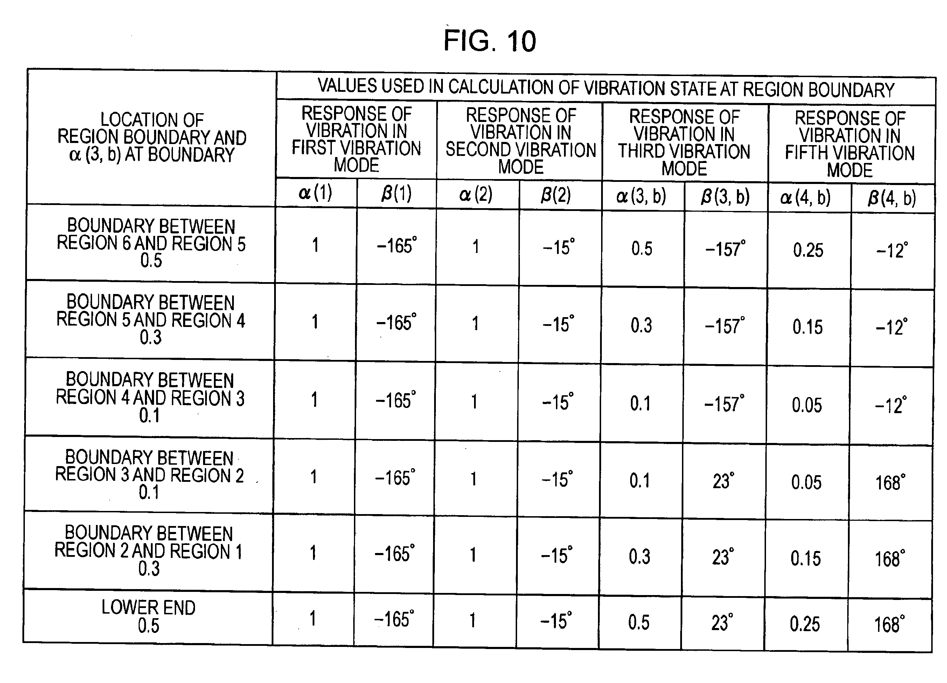

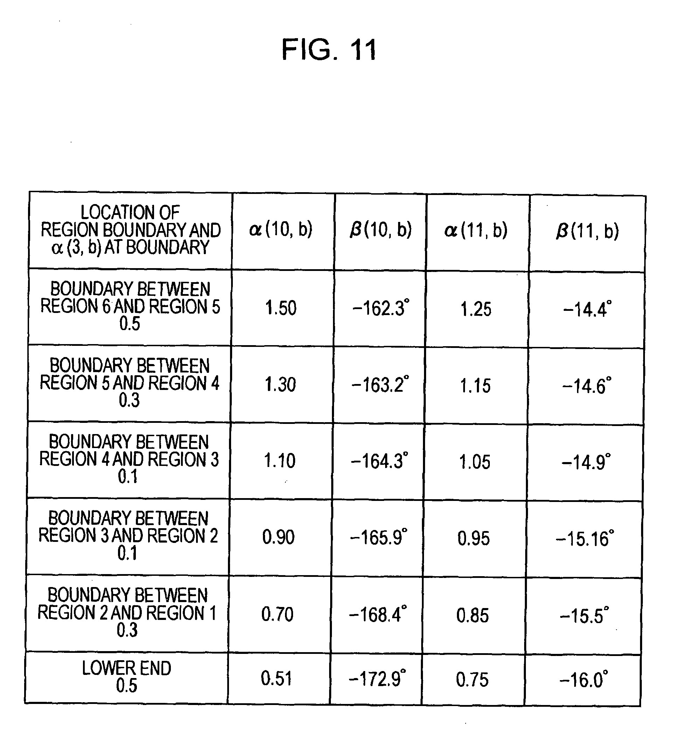

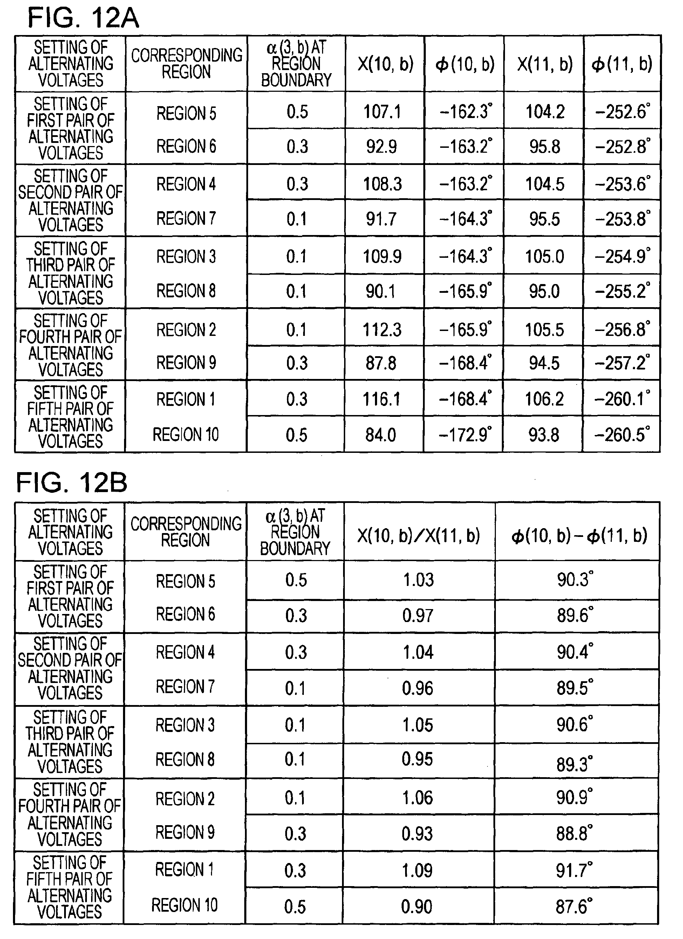

The vibration state at the region boundary is calculated as follows. Fig. 10 indicates values of $\alpha(1)$, $\beta(1)$, $\alpha(2)$, $\beta(2)$, $\alpha(3, b)$, $\beta(3, b)$, $\alpha(4, b)$ and $\beta(4, b)$ at each of the region boundaries. From the values indicated in Fig. 10 and the formulae (12), (14), (16) and (18), values of $\alpha(10, b)$, $\beta(10, b)$, $\alpha(11, b)$ and $\beta(11, b)$ at each of the region boundaries are provided as indicated in Fig. 11. From the values in Fig. 11, the values for the setting of the alternating voltages in Fig. 9B, and the formulae (11), (13), (15) and (17), the vibration states at the region boundaries corresponding to the settings of the respective pairs of alternating voltages are indicated in Fig. 12A.

The beneficial effect of this embodiment in comparison with the related art is described below.

As described above, the optimum vibration state for efficiently moving dust, etc. is a state where the 10th-order vibration and the 11th-order vibration have the same magnitude and the time phase difference between them is 90°. The value of $X(10, b)/X(11, b)$ and the value of $\phi(10, b) - \phi(11, b)$ can be used as indices representing the vibration state. The vibration state is better as $X(10, b)/X(11, b)$ is closer to 1, and it is also better as $\phi(10, b) - \phi(11, b)$ is closer to 90°.

In the setting of the driving voltages with the related-art described above, setting of one pair of the alternating voltages is used for the entire optical element 1. In other words, the voltage amplitude ratio and the time phase difference between the two driving voltages are constant. $X(1) = X(2) = X(10, b) = X(11, b)$ and $X(10, b)/X(11, b) = 1$ are held at the positions of the nodal lines parallel to the first direction A in the third and fourth vibration modes. Further, because of $\phi(1) = \phi(10, b)$, $\phi(2) = \phi(11, b)$, and $\phi(1) - \phi(2) = 90°$, $\phi(10, b) - \phi(11, b) = 90°$ is held. However, at the center and the upper and lower ends in the up-and-down direction (second direction B) where $\alpha(3, b)$ and $\alpha(4, b)$ have maximum values, for example, the vibration states greatly differ from that at the positions of the nodal lines. As described above, at the center, $X(10, b) = 150$, $\phi(10, b) = -162°$, $X(11, b) = 125$, and $\phi(11, b) = -254°$ are provided. Therefore, $X(10, b)/X(11, b) = 150/125 = 1.2$ and $\phi(10, b) - \phi(11, b) = -162° - (-254°) = 92°$ are resulted. At the upper and lower ends, $X(10, b) = 51$, $\phi(10, b) = -173°$, $X(11, b) = 75$, and $\phi(11, b) = -256°$ are provided. Therefore, $X(10, b)/X(11, b) = 51/75 = 0.68$ and $\phi(10, b) - \phi(11, b) = -173° - (-256°) = 83°$ are resulted. Thus, in the worse vibration state at the upper and lower ends, $X(10, b)/X(11, b) = 0.68$ and $\phi(10, b) - \phi(11, b) = 83°$ are provided. That worse vibration state differs from the optimum state by 32% in terms of $X(10, b)/X(11, b)$ and 7° in terms of $\phi(10, b) - \phi(11, b)$.

In contrast, with the setting of the driving voltages according to this embodiment, $X(10, b)/X(11, b)$ and $\phi(10, b) - \phi(11, b)$ at the region boundary of each of regions where the same pair of alternating voltages is set are calculated as indicated in Fig. 12B. The values of $X(10, b)$, $X(11, b)$, $\phi(10, b)$ and $\phi(11, b)$ indicated in Fig. 12A are used for the calculations.

In the driving procedure according to this embodiment, the setting of the driving voltages is successively changed over in time series from the setting of the first pair of alternating voltages to the setting of the fifth pair of alternating voltages, thereby changing over the amplitude distribution and the phase distribution of the composite vibration generated in the vibration member. Stated another way, in the present invention, the voltage amplitude ratio between the driving voltages is changed in time series from the voltage amplitude ratio between the first pair of driving voltages to the voltage amplitude ratio between the n-th driving voltages, or the time phase difference between the driving voltages is changed in time series from the time phase difference between the first pair of driving voltages to the time phase difference between the n-th driving voltages. As a result, the regions corresponding respectively to the first to fifth pairs of alternating voltages are each brought into the satisfactory vibration state. The vibration state in each of the corresponding regions is most worsened at the position of the region boundary as indicated in Fig. 12B. As seen from Fig. 12B, the worst one of the vibration states at the region boundaries occurs at the upper and lower ends of each of the region 1 and the region 10 with the setting of the fifth pair of alternating voltages, i.e., $X(10, b)/X(11, b) = 0.90$ and $\phi(10, b) - \phi(11, b) = 87.6°$. Comparing with the optimum state of $X(10, b)/X(11, b) = 1$ and $\phi(10, b) - \phi(11, b) = 90°$, $X(10, b)/X(11, b)$ differs by 10% and $\phi(10, b) - \phi(11, b)$ differs by 2.4°.

At the completion of the driving procedure, all positions in the optical element 1 are subjected to vibration states better than the above-mentioned worst vibration state. In the related art, as described above, comparing with the optimum state of $X(10, b)/X(11, b) = 1$ and $\phi(10, b) - \phi(11, b) = 90°$, $X(10, b)/X(11, b)$ differs by 32% and $\phi(10, b) - \phi(11, b)$ differs by 7°. Thus, in this embodiment, $X(10, b)/X(11, b)$ and $\phi(10, b) - \phi(11, b)$ are both improved. Accordingly, dust, etc. can be more efficiently moved at all the positions in the optical element 1. Further, even at the region boundaries, $X(10, b)$ and $X(11, b)$ can be provided as values closer to the object value $X(0) = 100$ than those with the related art. In the present invention, at least one of the voltage amplitude ratio and the time phase difference between the driving voltages may be changed to change the amplitude distribution of the composite vibration. However, it is more desirable to change both the voltage amplitude ratio and the time phase difference as in the embodiment. Further, in the present invention, the phase distribution of the composite vibration may also be changed in time series in addition to changing the amplitude distribution of the composite vibration in time series. Moreover, when the voltage amplitude ratio and the time phase difference between the driving voltages are changed in time series, they may be gradually changed or momentarily shifted (switched).

The vibrating device and the driving method according to the first embodiment may be employed in a scanner unit of a copying machine, which is another example of optical apparatuses, in order to remove dust, or may be used in a driving device for moving toner in the form of powder. With such an application, dust and powder present over a wide area can be efficiently moved, and a thinner dust removing device and driving device can be realized. Targets (driven objects) to be moved by the dust removing device according to the present invention are not limited to dust and power, and a solid, a gas, and a liquid can also be moved. The driving device according to the present invention drives a driven member by the vibrating device according to the present invention. Examples of the driven member include a structure (e.g., a holder for holding a lens) and a sheet member, which are to be driven. While the first to fourth vibration modes are regarded in the first embodiment as the vibration modes to be taken into consideration, the beneficial effects with the present invention can be further increased by considering one or more other vibration modes as well in calculating the setting values of the alternating voltages. Among the useless vibration modes, the vibration mode giving the greatest influence is the third vibration mode, and the extent of influence of the fourth vibration mode is relatively smaller than that of the third vibration mode. Accordingly, even when the fourth vibration mode is excluded from the calculations for the setting of the alternating voltages in some cases, the beneficial effects with the present invention can also be obtained. Moreover, in the first embodiment, the 10th-order out-of-plane bending vibration mode (first vibration mode) and the 11th-order out-of-plane bending vibration mode (second vibration mode) are used as the vibration modes that mainly contribute to moving dust. However, the present invention is not limited to such a combination of the vibration modes. For example, the primary out-of-plane bending vibration mode and the secondary out-of-plane bending vibration mode may be combined with each other. Alternatively, the m-th-order out-of-plane bending vibration mode and the n-th-order out-of-plane bending vibration mode may be combined with each other. In such a case, m and n are different natural numbers. Even in any combination of the vibration modes that mainly contribute to moving dust, the beneficial effects with the present invention can be obtained by driving the optical element while the regions and the alternating voltage are set in consideration of other one or more vibration modes than the combined vibration modes.

In the first embodiment, ten regions are set and regions where the vibration response is the same are selected from the ten regions in consideration of symmetry of the vibration response. The regions where the vibration response is the same are regarded as one group region where the same pair of alternating voltages is set. In such a manner, five group regions are set to which different pairs of alternating voltages are applied. In the present invention, however, the number of group regions in each of which the same pair of alternating voltages is set is not limited to five. When there are two or more regions where different pairs of alternating voltages are set, it is possible to obtain the beneficial effects with the present invention, i.e., the ability of efficiently moving driven objects, including dust, in the predetermined direction, by realizing the optimum vibration state for each region.

Further, the "setting of the alternating voltages" includes the setting of a voltage amplitude ratio between the alternating voltages and a time phase difference between the alternating voltages. The setting of the first pair of alternating voltages having the first voltage amplitude ratio and the first time phase difference is made for the first region of the vibration member. The setting of the second pair of alternating voltages having the second voltage amplitude ratio and the second time phase difference is made for the second region of the vibration member, the second region differing from the first region. Here, at least, the first voltage amplitude ratio and the second voltage amplitude ratio differ from each other, or the first time phase difference and the second time phase difference differ from each other. The beneficial effects with the present invention, i.e., the ability of efficiently moving driven objects, including dust, in the predetermined direction, can be obtained by changing over the setting of the first pair of alternating voltages and the setting of the second pair of alternating voltages when the vibration member is driven, thereby realizing the optimum vibration state for each region. Thus, in the present invention, the number of the regions is also not limited to the number described in the foregoing embodiment. Moreover, in the first embodiment, the third vibration mode and the fourth vibration mode having respective the same displacement distributions in the left-and-right direction (first direction A) as those in the first and second vibration modes are taken into consideration as the useless vibration modes. Therefore, the vibrations excited in the optical element 1 are not changed in their displacement distributions in the left-and-right direction (first direction A) by the vibrations in the third and fourth vibration modes. For that reason, divided regions are not set in the left-and-right direction (first direction A). Unlike the first embodiment, however, there is a case where the useless vibration mode may generate a relatively large magnitude of vibration in different displacement distribution in the left-and-right direction (first direction A) from those of the first and second vibration modes that mainly contribute to moving dust. In such a case, regions imaginarily dividing the optical element 1 in the left-and-right direction (first direction A) can also be set, as appropriate, in consideration of the above-described useless vibration mode. With such a driving method, the beneficial effects with the present invention, i.e., the ability of realizing the optimum vibration state for each region and efficiently moving the driven objects, including dust, in the predetermined direction, can be obtained even when the displacement distribution in the left-and-right direction (first direction A) is changed by the vibration in the useless vibration mode.

While, in the first embodiment, the value of $\phi(10, b) - \phi(11, b)$ to be set is 90°, the value is not limited to 90° in the present invention. It is just required that the time phase difference between the 10th-order vibration and the 11th-order vibration described above differs from each other. Further, by setting $\phi(10, b) - \phi(11, b)$ to be larger than -180° and smaller than 0°, the direction of moving dust, etc. can be reversed. The direction of moving dust, etc. can also be reversed by changing the combination of the driving voltages and the piezoelectric elements 2, to which the driving voltages are applied, such that the driving voltage E(1) is applied to the right piezoelectric element 2b and the driving voltage E(2) is applied to the left piezoelectric element 2a. The settings of the alternating voltages for reversing the direction of moving dust, etc. in such a way may be added to the driving procedure.

While the present invention has been described with reference to exemplary embodiments, it is to be understood that the invention is not limited to the disclosed exemplary embodiments.

**Reference Signs List**

1 optical element
2, 2a, 2b, 2c, 2d piezoelectric element
3 vibration member
4 image pickup device
5 optically active range (optically active area)
6 displacement distribution in vibration mode
7 displacement distribution in first vibration mode
8 displacement distribution in second vibration mode
9 split electrode
10 conductive paint
100 control circuit
101 power supply

**Claims**

1. A vibration member driving method comprising:

   applying at least two driving voltages to at least one electro-mechanical energy conversion element which is disposed in a vibration member so that a composite vibration is produced by generating a plurality of standing waves with a time phase difference set between the plurality of standing waves, the plurality of standing waves are different in order from each other; and
   changing at least one of a voltage amplitude ratio and a time phase difference between the at least two driving voltages such that an amplitude distribution of the composite vibration is changed.

2. The vibration member driving method according to Claim 1, wherein at least one of the voltage amplitude ratio and the time phase difference between the at least two driving voltages is changed such that the amplitude distribution and a phase distribution of the composite vibration are changed.

3. The vibration member driving method according to Claim 1 or 2, comprising at least one of:

   controlling successively change of the voltage amplitude ratio between the at least two driving voltages from a first voltage amplitude ratio to an n-th (n is an integer equal to or greater than 2) voltage amplitude ratio in time series; and
   controlling successively change of the time phase difference between the at least two driving voltages from a first time phase difference to an n-th time phase difference in time series,
   wherein the vibration member is imaginarily divided into first to n-th regions,
   wherein the first voltage amplitude ratio is a voltage amplitude ratio between at least two alternating voltages set for the first region, and the first time phase difference is a time phase difference between at least two alternating voltages set for the first region, and
   wherein the n-th voltage amplitude ratio is a voltage amplitude ratio between at least two alternating voltages set for the n-th region, and the n-th time phase difference is a time phase difference between at least two alternating voltages set for the n-th region.

4. The vibration member driving method according to Claim 3, wherein the driving method comprises at least one of:

   controlling successively change of the voltage amplitude ratio between the at least two driving voltages from the first voltage amplitude ratio to the n-th voltage amplitude ratio in time series in units of a predetermined time, and

controlling successively change of the time phase difference between the at least two driving voltages from the first time phase difference to the n-th time phase difference in time series in units of a predetermined time.

5. A control unit for a vibrating device which comprises a vibration member provided with at least one electro-mechanical energy conversion element,

wherein the control unit configured to apply at least two driving voltages to the at least one electro-mechanical energy conversion element so that a composite vibration is produced by generating a plurality of standing waves with a time phase difference set between the plurality of standing waves, the plurality of standing waves are different in order from each other,

wherein the control unit changes at least one of a voltage amplitude ratio and a time phase difference between the at least two driving voltages such that an amplitude distribution of the composite vibration is changed.

6. The control unit according to Claim 5, wherein at least one of the voltage amplitude ratio and the time phase difference between the at least two driving voltages is changed such that the amplitude distribution and a phase distribution of the composite vibration are changed.

7. The control unit according to Claim 5 or 6, wherein the control unit is configured to control at least one of:

successively change of the voltage amplitude ratio between the at least two driving voltages from a first voltage amplitude ratio to an n-th (n is an integer equal to or greater than 2)voltage amplitude ratio in time series; and successively change of the time phase difference between the at least two driving voltages from the first time phase difference to the n-th time phase difference in time series,

wherein at least one of a voltage amplitude ratio and a time phase difference between at least two alternating voltages is set in the control unit for each of the first to the n-th regions of the vibration member,

wherein the first voltage amplitude ratio is the voltage amplitude ratio between the alternating voltages set for the first region,

wherein the first time phase difference is the time phase difference between the alternating voltages set for the first region,

wherein the n-th voltage amplitude ration is the voltage amplitude ratio between the alternating voltages set for the n-th region, and

wherein the n-th time phase difference is the time phase difference between the alternating voltages set for the n-th region.

8. The control unit according to any one of Claims 5 to 7, wherein the control unit is configured to control at least one of:

successively change of the voltage amplitude ratio between the at least two driving voltages from the first voltage amplitude ratio to the n-th voltage amplitude ratio in time series in units of a predetermined time ; and successively change of the time phase difference between the at least two driving voltages from the first time phase difference to the n-th time phase difference in time series in units of a predetermined time.

9. A driving device comprising:

the control unit according to any one of Claims 5 to 8;
the vibrating device functionally connected to the control unit; and
a driven member,
the driven member being driven by the vibrating device.

10. The vibrating device according to any one of Claims 5 to 8, wherein the vibrating device functions as a dust removing device that moves dust on the vibration member with the composite vibration.

11. An optical apparatus comprising:

the control unit according to claim 5;
the vibrating device functionally connected to the control unit, which is disposed in an optical path; and
an image pickup device on which light having passed through the vibrating device is incident.

**Patentansprüche**

1. Schwingelementantriebsverfahren mit:

   Anlegen mindestens zweier Antriebsspannungen an mindestens einem elektromechanischen Energieumwandlungsteil, das in einem Schwingelement eingerichtet ist, sodass eine zusammengesetzte Schwingung erzeugt wird, indem eine Vielzahl von stehenden Wellen mit einer Zeitphasendifferenz erzeugt wird, die zwischen der Vielzahl von stehenden Wellen festgesetzt ist, wobei die Vielzahl von stehenden Wellen in einer Reihenfolge voneinander verschieden ist; und
   Ändern mindestens eines von einem Spannungsamplitudenverhältnis und einer Zeitphasendifferenz zwischen den mindestens zwei Antriebsspannungen, sodass eine Amplitudenverteilung der zusammengesetzten Schwingung geändert wird.

2. Schwingelementantriebsverfahren nach Anspruch 1, wobei mindestens eines von dem Spannungsamplitudenverhältnis und der Zeitphasendifferenz zwischen den mindestens zwei Antriebsspannungen geändert wird, sodass die Amplitudenverteilung und eine Phasenverteilung der zusammengesetzten Schwingung geändert werden.

3. Schwingelementantriebsverfahren nach Anspruch 1 oder 2, welches mindestens eines von Folgendem aufweist:

   nacheinander folgend Steuern einer Änderung eines Spannungsamplitudenverhältnisses zwischen den mindestens zwei Antriebsspannungen von einem ersten Spannungsamplitudenverhältnis zu einem n-ten (n ist eine ganze Zahl, die gleich oder größer als 2 ist) Spannungsamplitudenverhältnis in einer Zeitfolge; und
   nacheinander Steuern einer Änderung der Zeitphasendifferenz zwischen den mindestens zwei Antriebsspannungen von einer ersten Zeitphasendifferenz zu einer n-ten Zeitphasendifferenz in einer Zeitfolge,
   wobei das Schwingelement gedacht in erste bis n-te Regionen unterteilt ist,
   wobei das erste Spannungsamplitudenverhältnis ein Spannungsamplitudenverhältnis zwischen mindestens zwei abwechselnden Spannungen ist, die für die erste Region festgesetzt sind, und die erste Zeitphasendifferenz eine Zeitphasendifferenz zwischen mindestens zwei abwechselnden Spannungen ist, die für die erste Region festgesetzt sind, und,
   wobei das n-te Spannungsamplitudenverhältnis ein Spannungsamplitudenverhältnis zwischen mindestens zwei abwechselnden Spannungen ist, die für die n-te Region festgesetzt sind, und die n-te Zeitphasendifferenz eine Zeitphasendifferenz zwischen mindestens zwei abwechselnden Spannungen ist, die für die n-te Region festgesetzt sind.

4. Schwingelementantriebsverfahren nach Anspruch 3, wobei das Antriebsverfahren mindestens eines von Folgendem aufweist:

   nacheinander Steuern einer Änderung des Spannungsamplitudenverhältnisses zwischen den mindestens zwei Antriebsspannungen von dem ersten Spannungsamplitudenverhältnis zu dem n-ten Spannungsamplitudenverhältnis in einer Zeitfolge in Einheiten einer vorherbestimmten Zeit, und
   nacheinander Steuern einer Änderung der Zeitphasendifferenz zwischen den mindestens zwei Antriebsspannungen von der ersten Zeitphasendifferenz zu der n-ten Zeitphasendifferenz in einer Zeitfolge in Einheiten einer vorherbestimmten Zeit.

5. Steuerungseinheit für eine Schwingvorrichtung, die ein Schwingelement aufweist, das mit mindestens einem elektromechanischen Energieumwandlungsteil vorgesehen ist,
   wobei die Steuerungseinheit, die gestaltet ist, mindestens zwei Antriebsspannungen an dem mindestens einen elektromechanischen Energieumwandlungsteil anzulegen, sodass eine zusammengesetzte Schwingung erzeugt wird, indem eine Vielzahl von stehenden Wellen mit einer Zeitphasendifferenz, die zwischen der Vielzahl von stehenden Wellen festgesetzt ist, erzeugt wird, wobei die Vielzahl von stehenden Wellen in einer Reihenfolge voneinander verschieden ist,
   wobei die Steuerungseinheit mindestens eines von einem Spannungsamplitudenverhältnis und einer Zeitphasendifferenz zwischen den mindestens zwei Antriebsspannungen ändert, sodass eine Amplitudenverteilung der zusammengesetzten Schwingung geändert wird.

6. Steuerungseinheit nach Anspruch 5, wobei mindestens eines von dem Spannungsamplitudenverhältnis und der Zeitphasendifferenz zwischen den mindestens zwei Antriebsspannungen geändert wird, sodass die Amplitudenverteilung und eine Phasenverteilung der zusammengesetzten Schwingung geändert werden.

7. Steuerungseinheit nach Anspruch 5 oder 6, wobei die Steuerungseinheit gestaltet ist, mindestens eines von Folgendem zu steuern:

nacheinander eine Änderung des Spannungsamplitudenverhältnisses zwischen den mindestens zwei Antriebsspannungen von einem ersten Spannungsamplitudenverhältnis zu einem n-ten (n ist eine ganze Zahl, die gleich oder größer als 2 ist) Spannungsamplitudenverhältnis in einer Zeitfolge; und

nacheinander eine Änderung der Zeitphasendifferenz zwischen den mindestens zwei Antriebsspannungen von der ersten Zeitphasendifferenz zu der n-ten Zeitphasendifferenz in einer Zeitfolge,

wobei mindestens eines von einem Spannungsamplitudenverhältnis und einer Zeitphasendifferenz zwischen mindestens zwei abwechselnden Spannungen in der Steuerungseinheit für jeden von dem ersten zu dem n-ten Abschnitt des Schwingelements festgesetzt ist,

wobei das erste Spannungsamplitudenverhältnis das Spannungsamplitudenverhältnis zwischen den abwechselnden Spannungen ist, das für die erste Region festgesetzt sind,

wobei die erste Zeitphasendifferenz die Zeitphasendifferenz zwischen den abwechselnden Spannungen ist, die für die erste Region festgesetzt sind,

wobei das n-te Spannungsamplitudenverhältnis das Spannungsamplitudenverhältnis zwischen den abwechselnden Spannungen ist, die für die n-te Region festgesetzt sind, und

wobei die n-te Zeitphasendifferenz die Zeitphasendifferenz zwischen den abwechselnden Spannungen ist, die für die n-te Region festgesetzt sind.

8. Steuerungseinheit nach einem von Ansprüchen 5 bis 7, wobei die Steuerungseinheit gestaltet ist, mindestens eines von Folgendem zu steuern:

nacheinander eine Änderung des Spannungsamplitudenverhältnisses zwischen den mindestens zwei Antriebsspannungen von dem ersten Spannungsamplitudenverhältnis zu dem n-ten Spannungsamplitudenverhältnis in einer Zeitfolge in Einheiten einer vorherbestimmten Zeit; und

nacheinander eine Änderung der Zeitphasendifferenz zwischen den mindestens zwei Antriebsspannungen von der ersten Zeitphasendifferenz zu der n-ten Zeitphasendifferenz in einer Zeitfolge in Einheiten einer vorherbestimmten Zeit.

9. Antriebsvorrichtung mit:

der Steuerungseinheit nach einem von Ansprüchen 5 bis 8;

der Schwingvorrichtung, die funktionell mit der Steuerungseinheit verbunden ist; und

einem Antriebselement,

wobei das Antriebselement von der Schwingvorrichtung angetrieben wird.

10. Schwingvorrichtung nach einem von Ansprüchen 5 bis 8, wobei die Schwingvorrichtung als eine Staubentfernungsvorrichtung dient, die Staub auf dem Schwingelement mit der zusammengesetzten Schwingung bewegt.

11. Optische Apparatur mit:

der Steuerungseinheit nach Anspruch 5;

der Schwingvorrichtung, die funktionell mit der Steuerungseinheit verbunden ist, die in einem optischen Pfad eingerichtet ist; und

einer Bildaufnahmevorrichtung, auf der Licht, das die Schwingvorrichtung durchquert hat, einfällt.

**Revendications**

1. Procédé d'attaque d'élément de vibration, comprenant :

l'application d'au moins deux tensions d'attaque à au moins un élément de conversion d'énergie électromécanique qui est disposé dans un élément de vibration de telle sorte qu'une vibration composite soit produite par la génération d'une pluralité d'ondes stationnaires avec une différence de phase dans le temps établie entre la pluralité d'ondes stationnaires, la pluralité d'ondes stationnaires étant d'ordre différent les unes vis-à-vis des autres ; et

le changement d'au moins l'un d'un rapport d'amplitude de tension et d'une différence de phase dans le temps entre les tensions d'attaque au nombre d'au moins deux, de telle sorte qu'une répartition d'amplitude de la vibration composite soit changée.

**2.** Procédé d'attaque d'élément de vibration selon la revendication 1, dans lequel au moins l'un du rapport d'amplitude de tension et de la différence de phase dans le temps entre les tensions d'attaque au nombre d'au moins deux est changé, de telle sorte que la répartition d'amplitude et une répartition de phase de la vibration composite soit changées.

**3.** Procédé d'attaque d'élément de vibration selon la revendication 1 ou 2, comprenant au moins l'une parmi :

la commande d'un changement successif du rapport d'amplitude de tension entre les tensions d'attaque au nombre d'au moins deux d'un premier rapport d'amplitude de tension à un $n^{\text{ème}}$ (n est un entier supérieur ou égal à 2) rapport d'amplitude de tension en série dans le temps ; et

la commande d'un changement successif de la différence de phase dans le temps entre les tensions d'attaque au nombre d'au moins deux d'une première différence de phase dans le temps à une $n^{\text{ème}}$ différence de phase dans le temps en série dans le temps,

dans lequel l'élément de vibration est divisé de façon imaginaire en première à $n^{\text{ème}}$ régions,

dans lequel le premier rapport d'amplitude de tension est un rapport d'amplitude de tension entre au moins deux tensions alternatives établi pour la première région, et la première différence de phase dans le temps est une différence de phase dans le temps entre au moins deux tensions alternatives établie pour la première région, et

dans lequel le $n^{\text{ème}}$ rapport d'amplitude de tension est un rapport d'amplitude de tension entre au moins deux tensions alternatives établi pour la $n^{\text{ème}}$ région, et la $n^{\text{ème}}$ différence de phase dans le temps est une différence de phase dans le temps entre au moins deux tensions alternatives établie pour la $n^{\text{ème}}$ région.

**4.** Procédé d'attaque d'élément de vibration selon la revendication 3, dans lequel le procédé d'attaque comprend au moins l'une parme :

la commande d'un changement successif du rapport d'amplitude de tension entre les tensions d'attaque au nombre d'au moins deux du premier rapport d'amplitude de tension au $n^{\text{ème}}$ rapport d'amplitude de tension en série dans le temps par unités d'un temps prédéterminé, et

la commande d'un changement successif de la différence de phase dans le temps entre les tensions d'attaque au nombre d'au moins deux de la première différence de phase dans le temps à la $n^{\text{ème}}$ différence de phase dans le temps en série dans le temps par unités d'un temps prédéterminé.

**5.** Unité de commande pour un dispositif de vibration, qui comprend un élément de vibration muni d'au moins un élément de conversion d'énergie électromécanique,

dans laquelle l'unité de commande est configurée de façon à appliquer au moins deux tensions d'attaque à l'élément de conversion d'énergie électromécanique au nombre d'au moins un de telle sorte qu'une vibration composite soit produite par la génération d'une pluralité d'ondes stationnaires avec une différence de phase dans le temps établie entre la pluralité d'ondes stationnaires, la pluralité d'ondes stationnaires étant d'ordre différent les unes vis-à-vis des autres,

dans laquelle l'unité de commande change au moins l'un d'un rapport d'amplitude de tension et d'une différence de phase dans le temps entre les tensions d'attaque au nombre d'au moins deux, de telle sorte qu'une répartition d'amplitude de la vibration composite soit changée.

**6.** Unité de commande selon la revendication 5, dans laquelle au moins l'un du rapport d'amplitude de tension et de la différence de phase dans le temps entre les tensions d'attaque au nombre d'au moins deux est changé, de telle sorte que la répartition d'amplitude et une répartition de phase de la vibration composite soit changées.

**7.** Unité de commande selon la revendication 5 ou 6, dans laquelle l'unité de commande est configurée de façon à commander au moins l'un parmi :

un changement successif du rapport d'amplitude de tension entre les tensions d'attaque au nombre d'au moins deux d'un premier rapport d'amplitude de tension à un $n^{\text{ème}}$ (n est un entier supérieur ou égal à 2) rapport d'amplitude de tension en série dans le temps ; et

un changement successif de la différence de phase dans le temps entre les tensions d'attaque au nombre d'au moins deux de la première différence de phase dans le temps à la $n^{\text{ème}}$ différence de phase dans le temps en série dans le temps,

dans laquelle au moins l'un d'un rapport d'amplitude de tension et de la différence de phase dans le temps entre au moins deux tensions alternatives est établi dans l'unité de commande pour chacune des première à $n^{\text{ème}}$ régions de l'élément de vibration,

dans laquelle le premier rapport d'amplitude de tension est le rapport d'amplitude de tension entre les tensions alternatives établi pour la première région,

dans laquelle la première différence de phase dans le temps est la différence de phase dans le temps entre les tensions alternatives établie pour la première région,

dans laquelle le $n^{\text{ème}}$ rapport d'amplitude de tension est le rapport d'amplitude de tension entre les tensions alternatives établi pour la $n^{\text{ème}}$ région, et

dans laquelle la $n^{\text{ème}}$ différence de phase dans le temps est la différence de phase dans le temps entre les tensions alternatives établie pour la $n^{\text{ème}}$ région.

8. Unité de commande selon l'une quelconque des revendications 5 à 7, dans laquelle l'unité de commande est configurée de façon à commander au moins l'un parmi :

un changement successif du rapport d'amplitude de tension entre les tensions d'attaque au nombre d'au moins deux du premier rapport d'amplitude de tension au $n^{\text{ème}}$ rapport d'amplitude de tension en série dans le temps par unités d'un temps prédéterminé ; et

un changement successif de la différence de phase dans le temps entre les tensions d'attaque au nombre d'au moins deux de la première différence de phase dans le temps à la $n^{\text{ème}}$ différence de phase dans le temps en série dans le temps par unités d'un temps prédéterminé.

9. Dispositif d'attaque, comprenant :

l'unité de commande selon l'une quelconque des revendications 5 à 8 ;
le dispositif de vibration connecté de façon fonctionnelle à l'unité de commande ; et
un élément attaqué,
l'élément attaqué étant attaqué par le dispositif de vibration.

10. Dispositif de vibration selon l'une quelconque des revendications 5 à 8, dans lequel le dispositif de vibration joue le rôle de dispositif de retrait de poussière, qui déplace de la poussière sur l'élément de vibration avec la vibration composite.

11. Appareil optique, comprenant :

l'unité de commande selon la revendication 5 ;
le dispositif de vibration connecté de façon fonctionnelle à l'unité de commande, qui est disposé dans un trajet optique ; et
un dispositif de prise d'image sur lequel une lumière ayant traversé le dispositif de vibration est incidente.

# FIG. 1

# FIG. 2

## FIG. 3A

## FIG. 3B

# FIG. 4

# FIG. 5A

# FIG. 5B

FIG. 6A

FIG. 6B

FIG. 6C

FIG. 6D

## FIG. 7A

| POSITION IN UP-AND-DOWN DIRECTION | RANGE OF $\alpha$ (3, b) | VALUE OF $\beta$ (3, b) | REGION | SETTING OF ALTERNATING VOLTAGES |
|---|---|---|---|---|
| NEAR UPPER END | 0.3—0.5 | 23° | REGION 1 | SETTING OF FIFTH PAIR OF ALTERNATING VOLTAGES |
| ↑ | 0.1—0.3 | 23° | REGION 2 | SETTING OF FOURTH PAIR OF ALTERNATING VOLTAGES |
| ↑ | 0—0.1 | 23° OR −157° | REGION 3 | SETTING OF THIRD PAIR OF ALTERNATING VOLTAGES |
| ↑ | 0.1—0.3 | −157° | REGION 4 | SETTING OF SECOND PAIR OF ALTERNATING VOLTAGES |
| NEAR CENTER | 0.3—0.5 | −157° | REGION 5 | SETTING OF FIRST PAIR OF ALTERNATING VOLTAGES |
| | 0.3—0.5 | −157° | REGION 6 | SETTING OF FIRST PAIR OF ALTERNATING VOLTAGES |
| ↓ | 0.1—0.3 | −157° | REGION 7 | SETTING OF SECOND PAIR OF ALTERNATING VOLTAGES |
| ↓ | 0—0.1 | 23° OR −157° | REGION 8 | SETTING OF THIRD PAIR OF ALTERNATING VOLTAGES |
| ↓ | 0.1—0.3 | 23° | REGION 9 | SETTING OF THIRD PAIR OF ALTERNATING VOLTAGES |
| NEAR LOWER END | 0.3—0.5 | 23° | REGION 10 | SETTING OF FIFTH PAIR OF ALTERNATING VOLTAGES |

## FIG. 7B

## FIG. 7C

REGION 10
REGION 9
REGION 8
REGION 7
REGION 6
REGION 5
REGION 4
REGION 3
REGION 2
REGION 1

# FIG. 8

| SETTING OF ALTERNATING VOLTAGES | VALUES USED IN CALCULATION FOR SETTING OF ALTERNATING VOLTAGES | | | | | | | |
|---|---|---|---|---|---|---|---|---|
| | RESPONSE OF VIBRATION IN FIRST VIBRATION MODE | | RESPONSE OF VIBRATION IN SECOND VIBRATION MODE | | RESPONSE OF VIBRATION IN THIRD VIBRATION MODE | | RESPONSE OF VIBRATION IN FIFTH VIBRATION MODE | |
| | $\alpha(1)$ | $\beta(1)$ | $\alpha(2)$ | $\beta(2)$ | $\alpha(3, b)$ | $\beta(3, b)$ | $\alpha(4, b)$ | $\beta(4, b)$ |
| SETTING OF FIRST PAIR OF ALTERNATING VOLTAGES | 1 | $-165°$ | 1 | $-15°$ | 0.4 | $-157°$ | 0.2 | $-12°$ |
| SETTING OF SECOND PAIR OF ALTERNATING VOLTAGES | 1 | $-165°$ | 1 | $-15°$ | 0.2 | $-157°$ | 0.1 | $-12°$ |
| SETTING OF THIRD PAIR OF ALTERNATING VOLTAGES | 1 | $-165°$ | 1 | $-15°$ | 0 | $-157°$ OR $23°$ | 0 | $-12°$ OR $168°$ |
| SETTING OF FOURTH PAIR OF ALTERNATING VOLTAGES | 1 | $-165°$ | 1 | $-15°$ | 0.2 | $23°$ | 0.1 | $168°$ |
| SETTING OF FIFTH PAIR OF ALTERNATING VOLTAGES | 1 | $-165°$ | 1 | $-15°$ | 0.4 | $23°$ | 0.2 | $168°$ |

EP 2 692 052 B1

# FIG. 9A

| SETTING OF ALTERNATING VOLTAGES | $\alpha$ (10, b) | $\beta$ (10, b) | $\alpha$ (11, b) | $\beta$ (11, b) |
|---|---|---|---|---|
| SETTING OF FIRST PAIR OF ALTERNATING VOLTAGES | 1.40 | −162.7° | 1.20 | −14.5° |
| SETTING OF SECOND PAIR OF ALTERNATING VOLTAGES | 1.20 | −163.7° | 1.10 | −14.7° |
| SETTING OF THIRD PAIR OF ALTERNATING VOLTAGES | 1.00 | −165.0° | 1.00 | −15.0° |
| SETTING OF FOURTH PAIR OF ALTERNATING VOLTAGES | 0.80 | −167.0° | 0.90 | −15.3° |
| SETTING OF FIFTH PAIR OF ALTERNATING VOLTAGES | 0.61 | −170.3° | 0.80 | −15.8° |

# FIG. 9B

| SETTING OF ALTERNATING VOLTAGES | V (DIFFERENCE) | θ (DIFFERENCE) | V (SUM) | θ (SUM) |
|---|---|---|---|---|
| SETTING OF FIRST PAIR OF ALTERNATING VOLTAGES | 71.6 | 0.0° | 83.3 | −238.2° |
| SETTING OF SECOND PAIR OF ALTERNATING VOLTAGES | 83.4 | 0.0° | 90.9 | −238.9° |
| SETTING OF THIRD PAIR OF ALTERNATING VOLTAGES | 100.0 | 0.0° | 100.0 | −240.0° |
| SETTING OF FOURTH PAIR OF ALTERNATING VOLTAGES | 124.6 | 0.0° | 111.1 | −241.7° |
| SETTING OF FIFTH PAIR OF ALTERNATING VOLTAGES | 164.9 | 0.0° | 124.9 | −244.5° |

# FIG. 9C

| SETTING OF ALTERNATING VOLTAGES | V(1) | θ(1) | V(2) | θ(2) | $\varepsilon$ | $\delta$ |
|---|---|---|---|---|---|---|
| SETTING OF FIRST PAIR OF ALTERNATING VOLTAGES | 76.1 | 68.7° | 135.5 | 148.5° | 1.781 | 79.8° |
| SETTING OF SECOND PAIR OF ALTERNATING VOLTAGES | 86.0 | 64.9° | 151.9 | 149.1° | 1.766 | 84.2° |
| SETTING OF THIRD PAIR OF ALTERNATING VOLTAGES | 100.0 | 60.0° | 173.2 | 150.0° | 1.732 | 90.0° |
| SETTING OF FOURTH PAIR OF ALTERNATING VOLTAGES | 121.4 | 53.7° | 202.5 | 151.1° | 1.668 | 97.4° |
| SETTING OF FIFTH PAIR OF ALTERNATING VOLTAGES | 158.4 | 45.4° | 246.0 | 152.7° | 1.553 | 107.3° |

## FIG. 10

| LOCATION OF REGION BOUNDARY AND $\alpha(3, b)$ AT BOUNDARY | VALUES USED IN CALCULATION OF VIBRATION STATE AT REGION BOUNDARY | | | | | | | |
|---|---|---|---|---|---|---|---|---|
| | RESPONSE OF VIBRATION IN FIRST VIBRATION MODE | | RESPONSE OF VIBRATION IN SECOND VIBRATION MODE | | RESPONSE OF VIBRATION IN THIRD VIBRATION MODE | | RESPONSE OF VIBRATION IN FIFTH VIBRATION MODE | |
| | $\alpha(1)$ | $\beta(1)$ | $\alpha(2)$ | $\beta(2)$ | $\alpha(3, b)$ | $\beta(3, b)$ | $\alpha(4, b)$ | $\beta(4, b)$ |
| BOUNDARY BETWEEN REGION 6 AND REGION 5 0.5 | 1 | −165° | 1 | −15° | 0.5 | −157° | 0.25 | −12° |
| BOUNDARY BETWEEN REGION 5 AND REGION 4 0.3 | 1 | −165° | 1 | −15° | 0.3 | −157° | 0.15 | −12° |
| BOUNDARY BETWEEN REGION 4 AND REGION 3 0.1 | 1 | −165° | 1 | −15° | 0.1 | −157° | 0.05 | −12° |
| BOUNDARY BETWEEN REGION 3 AND REGION 2 0.1 | 1 | −165° | 1 | −15° | 0.1 | 23° | 0.05 | 168° |
| BOUNDARY BETWEEN REGION 2 AND REGION 1 0.3 | 1 | −165° | 1 | −15° | 0.3 | 23° | 0.15 | 168° |
| LOWER END 0.5 | 1 | −165° | 1 | −15° | 0.5 | 23° | 0.25 | 168° |

EP 2 692 052 B1

# FIG. 11

| LOCATION OF REGION BOUNDARY AND $\alpha$ (3, b) AT BOUNDARY | $\alpha$ (10, b) | $\beta$(10, b) | $\alpha$ (11, b) | $\beta$(11, b) |
|---|---|---|---|---|
| BOUNDARY BETWEEN REGION 6 AND REGION 5 0.5 | 1.50 | −162.3° | 1.25 | −14.4° |
| BOUNDARY BETWEEN REGION 5 AND REGION 4 0.3 | 1.30 | −163.2° | 1.15 | −14.6° |
| BOUNDARY BETWEEN REGION 4 AND REGION 3 0.1 | 1.10 | −164.3° | 1.05 | −14.9° |
| BOUNDARY BETWEEN REGION 3 AND REGION 2 0.1 | 0.90 | −165.9° | 0.95 | −15.16° |
| BOUNDARY BETWEEN REGION 2 AND REGION 1 0.3 | 0.70 | −168.4° | 0.85 | −15.5° |
| LOWER END 0.5 | 0.51 | −172.9° | 0.75 | −16.0° |

## FIG. 12A

| SETTING OF ALTERNATING VOLTAGES | CORRESPONDING REGION | $\alpha$ (3, b) AT REGION BOUNDARY | X(10, b) | $\phi$(10, b) | X(11, b) | $\phi$(11, b) |
|---|---|---|---|---|---|---|
| SETTING OF FIRST PAIR OF ALTERNATING VOLTAGES | REGION 5 | 0.5 | 107.1 | −162.3° | 104.2 | −252.6° |
| | REGION 6 | 0.3 | 92.9 | −163.2° | 95.8 | −252.8° |
| SETTING OF SECOND PAIR OF ALTERNATING VOLTAGES | REGION 4 | 0.3 | 108.3 | −163.2° | 104.5 | −253.6° |
| | REGION 7 | 0.1 | 91.7 | −164.3° | 95.5 | −253.8° |
| SETTING OF THIRD PAIR OF ALTERNATING VOLTAGES | REGION 3 | 0.1 | 109.9 | −164.3° | 105.0 | −254.9° |
| | REGION 8 | 0.1 | 90.1 | −165.9° | 95.0 | −255.2° |
| SETTING OF FOURTH PAIR OF ALTERNATING VOLTAGES | REGION 2 | 0.1 | 112.3 | −165.9° | 105.5 | −256.8° |
| | REGION 9 | 0.3 | 87.8 | −168.4° | 94.5 | −257.2° |
| SETTING OF FIFTH PAIR OF ALTERNATING VOLTAGES | REGION 1 | 0.3 | 116.1 | −168.4° | 106.2 | −260.1° |
| | REGION 10 | 0.5 | 84.0 | −172.9° | 93.8 | −260.5° |

## FIG. 12B

| SETTING OF ALTERNATING VOLTAGES | CORRESPONDING REGION | $\alpha$ (3, b) AT REGION BOUNDARY | X(10, b)/X(11, b) | $\phi$(10, b) − $\phi$(11, b) |
|---|---|---|---|---|
| SETTING OF FIRST PAIR OF ALTERNATING VOLTAGES | REGION 5 | 0.5 | 1.03 | 90.3° |
| | REGION 6 | 0.3 | 0.97 | 89.6° |
| SETTING OF SECOND PAIR OF ALTERNATING VOLTAGES | REGION 4 | 0.3 | 1.04 | 90.4° |
| | REGION 7 | 0.1 | 0.96 | 89.5° |
| SETTING OF THIRD PAIR OF ALTERNATING VOLTAGES | REGION 3 | 0.1 | 1.05 | 90.6° |
| | REGION 8 | 0.1 | 0.95 | 89.3° |
| SETTING OF FOURTH PAIR OF ALTERNATING VOLTAGES | REGION 2 | 0.1 | 1.06 | 90.9° |
| | REGION 9 | 0.3 | 0.93 | 88.8° |
| SETTING OF FIFTH PAIR OF ALTERNATING VOLTAGES | REGION 1 | 0.3 | 1.09 | 91.7° |
| | REGION 10 | 0.5 | 0.90 | 87.6° |

# FIG. 13A

# FIG. 13B

# FIG. 14A

DISPLACEMENTS OF PRIMARY AND SECONDARY BENDING VIBRATIONS

DISPLACEMENT OF VIBRATION MEMBER

EP 2 692 052 B1

# FIG. 14B

DISPLACEMENTS OF PRIMARY AND
SECONDARY BENDING VIBRATIONS

DISPLACEMENT OF VIBRATION MEMBER

EP 2 692 052 B1

# FIG. 15A

DISPLACEMENTS OF PRIMARY AND SECONDARY BENDING VIBRATIONS

DISPLACEMENT OF VIBRATION MEMBER

# FIG. 15B

DISPLACEMENTS OF PRIMARY AND SECONDARY BENDING VIBRATIONS

DISPLACEMENT OF VIBRATION MEMBER

EP 2 692 052 B1

# FIG. 16A

DISPLACEMENTS OF PRIMARY AND SECONDARY BENDING VIBRATIONS

DISPLACEMENT OF VIBRATION MEMBER

EP 2 692 052 B1

# FIG. 16B

DISPLACEMENTS OF PRIMARY AND SECONDARY BENDING VIBRATIONS

DISPLACEMENT OF VIBRATION MEMBER

EP 2 692 052 B1

# FIG. 17

DISPLACEMENTS OF PRIMARY AND SECONDARY BENDING VIBRATIONS

DISPLACEMENT OF VIBRATION MEMBER

EP 2 692 052 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2008207170 A
- WO 2008093884 A1
- US 20090206698 A1
- US 20060207290 A1
- US 5001404 A